(19) Europäisches Patentamt / European Patent Office / Office européen des brevets

(11) **EP 4 183 573 A1**

(12) **EUROPEAN PATENT APPLICATION**
published in accordance with Art. 153(4) EPC

(43) Date of publication:
**24.05.2023 Bulletin 2023/21**

(21) Application number: **21841832.5**

(22) Date of filing: **16.07.2021**

(51) International Patent Classification (IPC):
**B32B 9/00** $^{(2006.01)}$  **G02B 1/11** $^{(2015.01)}$
**G02B 1/115** $^{(2015.01)}$  **G02B 1/14** $^{(2015.01)}$
**G02B 1/18** $^{(2015.01)}$  **C23C 14/06** $^{(2006.01)}$
**B32B 7/023** $^{(2019.01)}$

(52) Cooperative Patent Classification (CPC):
**B32B 7/023; B32B 9/00; C23C 14/06; G02B 1/11;
G02B 1/115; G02B 1/14; G02B 1/18**

(86) International application number:
**PCT/JP2021/026794**

(87) International publication number:
**WO 2022/014701 (20.01.2022 Gazette 2022/03)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **17.07.2020  JP 2020123317
02.03.2021  JP 2021032929**

(71) Applicant: **Dexerials Corporation
Shimotsuke-shi, Tochigi 323-0194 (JP)**

(72) Inventors:
• **SUZUKI Tsuguto
Shimotsuke-shi, Tochigi 323-0194 (JP)**
• **HUANG Zhen
Shimotsuke-shi, Tochigi 323-0194 (JP)**
• **SUZUKI Katsutoshi
Shimotsuke-shi, Tochigi 323-0194 (JP)**
• **WATANABE Takahisa
Shimotsuke-shi, Tochigi 323-0194 (JP)**
• **KIBUSHI Yuko
Shimotsuke-shi, Tochigi 323-0194 (JP)**
• **KOBAYASHI Tomoaki
Shimotsuke-shi, Tochigi 323-0194 (JP)**

(74) Representative: **Lavoix
Bayerstraße 83
80335 München (DE)**

(54) **METHOD FOR PRODUCING OPTICAL MULTILAYER BODY**

(57)    This method for producing an optical laminate is a method for producing an optical laminate including a plastic film, an adhesion layer, an optical function layer, and an antifouling layer which are laminated in this order. The method includes an adhesion layer forming step of forming an adhesion layer, an optical function layer forming step of forming an optical function layer, a surface treatment step of performing glow discharge treatment of a surface of the optical function layer, and an antifouling layer forming step of forming an antifouling layer on the optical function layer which has been subjected to surface treatment. An integrated output of the glow discharge treatment is 130 W·min/m² to 2000 W·min/m².

FIG. 1

**Description**

TECHNICAL FIELD

The present invention relates to a method for producing an optical laminate. The present application claims priority on Japanese Patent Application No. 2020-123317 filed on July 17, 2020, and Japanese Patent Application No. 2021-032929 filed on March 2, 2021, the contents of which are incorporated herein by reference.

BACKGROUND ART

For example, in flat panel displays (FPDs), touch panels, solar batteries, and the like, various antireflection films are used as optical laminates for surface antireflection. In the related art, regarding an antireflection film, an antireflection film including a multilayer film in which a high refractive index layer and a low refractive index layer are sequentially laminated on a transparent substrate has been proposed. Generally, an antifouling layer (surface protection layer) is formed on an outermost surface of such an antireflection film for the purpose of surface protection and antifouling.
Recently, antireflection films (optical laminates) have been widely used in touch panels of smartphones and various operation instruments. Accordingly, improvement in wear resistance of optical laminates is required.
For example, Patent Document 1 discloses a transparent substrate laminate of which wear resistance is improved by restricting a fluorine content included in a constituent material of an antifouling layer to be within a particular range.
Patent Document 2 discloses a method for forming an antifouling layer in which at least one surface of a base material to be treated is pretreated before an antifouling layer is formed and an antifouling layer is formed on this pretreated surface. In addition, Patent Document 2 discloses that pretreatment is any of a high-frequency discharge plasma method, an electron beam method, an ion beam method, a vapor deposition method, a sputtering method, an alkaline treatment method, an acid treatment method, a corona treatment method, and an atmospheric pressure glow discharge plasma method.
Patent Document 3 discloses a method for producing an antifouling optical article, in which an antireflection film is formed on a substrate surface by vapor deposition, next plasma treatment is performed by introducing oxygen or argon, and then an antifouling layer is formed by vacuum vapor deposition with a fluorine-containing organosilicon compound.

PRIOR ART DOCUMENTS

Patent Document

    Patent Document 1: PCT International Publication No. WO2019/078313
    Patent Document 2: Japanese Unexamined Patent Application, First Publication No. 2006-175438
    Patent Document 3: Japanese Unexamined Patent Application, First Publication No. 2005-301208
    Patent Document 4: Japanese Patent No. 6542970

DISCLOSURE OF INVENTION

Problems to be Solved by the Invention

However, the transparent substrate laminate disclosed in Patent Document 1 has a problem that unreacted substances contributing to wear resistance may be rubbed off when friction repeatedly occurs so that high wear resistance may not be able to be maintained. There has been a demand for an optical laminate including an antifouling layer in which high wear resistance can be maintained against repeated friction.
The present invention has been made in consideration of the foregoing problems, and an object thereof is to provide a method for producing an optical laminate having excellent durability.

Solutions for Solving the Problems

In order to resolve the foregoing problems, the present invention proposes the following means.

    [1] A method for producing an optical laminate according to a first aspect of the present invention is a method for producing an optical laminate including a plastic film, an adhesion layer, an optical function layer, and an antifouling layer which are laminated in this order. The method for producing an optical laminate includes an adhesion layer forming step of forming an adhesion layer, an optical function layer forming step of forming an optical function layer, a surface treatment step of performing treatment of a surface of the optical function layer such that a rate of change in surface roughness expressed by the following Expression (1) becomes 1% to 25% or a rate of change in average length of elements expressed by the following Expression (2) becomes 7 to 65%, and an antifouling layer forming step of forming an antifouling layer on the optical function layer which has been subjected to surface treatment.

$$\text{Rate of change in surface roughness (\%)} = ((Ra2/Ra1)-1) \times 100 \ (\%) \ ... \ \text{Expression (1)}$$

(in Expression (1), Ra1 indicates a surface roughness (Ra) of the optical function layer before surface treatment, and Ra2 indicates the surface roughness (Ra) of the optical function layer after surface treatment)

$$\text{Rate of change in average length of elements (\%)} = ((RSm2/RSm1)-1) \times 100 \ (\%) \ ... \ \text{Expression (2)}$$

(in Expression (2), RSm1 indicates an average length (RSm) of elements of the optical function layer before surface treatment, and RSm2 indicates the average length (RSm) of elements of the optical function layer after surface treatment)

[2] A method for producing an optical laminate according to a second aspect of the present invention is a method for producing an optical laminate including a plastic film, an adhesion layer, an optical function layer, and an antifouling layer which are laminated in this order. The method for producing an optical laminate includes an adhesion layer forming step of forming an adhesion layer, an optical function layer forming step of forming an optical function layer, a surface treatment step of performing glow discharge treatment of a surface of the optical function layer, and an antifouling layer forming step of forming an antifouling layer on the optical function layer which has been subjected to surface treatment. An integrated output of the glow discharge treatment is 130 W·min/m$^2$ to 2000 W·min/m$^2$.

[3] In the method for producing an optical laminate according to the foregoing aspect, the adhesion layer and the optical function layer may be formed by sputtering.

[4] In the method for producing an optical laminate according to the foregoing aspect, in the antifouling layer forming step, the antifouling layer may be formed by vacuum vapor deposition.

[5] In the method for producing an optical laminate according to the foregoing aspect, the adhesion layer forming step, the optical function layer forming step, the surface treatment step, and the antifouling layer forming step may be consecutively performed in a decompressed state.

[6] The method for producing an optical laminate according to the foregoing aspect may further include a hard coating layer forming step of forming a hard coating layer before the adhesion layer forming step.

[7] In the method for producing an optical laminate according to the foregoing aspect, the optical function layer may include any one selected from an antireflection layer and a selective reflection layer.

[8] In the method for producing an optical laminate according to the foregoing aspect, the optical function layer may include a low refractive index layer.

[9] In the method for producing an optical laminate according to the foregoing aspect, the optical function layer forming step may be a step of forming a laminate by alternately laminating a low refractive index layer and a high refractive index layer.

[10] In the method for producing an optical laminate according to the foregoing aspect, in the surface treatment step, a surface of the low refractive index layer may be treated.

[11] In the method for producing an optical laminate according to the foregoing aspect, the low refractive index layer may include a metal oxide.

[12] An optical laminate according to a third aspect of the present invention is an optical laminate including a transparent substrate, an adhesion layer, an optical function layer, and an antifouling layer which are laminated in this order. The antifouling layer includes a vapor-deposited film in which an antifouling material is vapor-deposited.

[13] In the optical laminate according to the foregoing aspect, the optical function layer may include any one selected from an antireflection layer and a selective reflection layer.

[14] In the optical laminate according to the foregoing aspect, the optical function layer may include a low refractive index layer.

[15] In the optical laminate according to the foregoing aspect, the optical function layer may include a laminate in which a low refractive index layer and a high refractive index layer are alternately laminated.

[16] In the optical laminate according to the foregoing aspect, the antifouling layer may be provided in contact with the low refractive index layer.

[17] In the optical laminate according to the foregoing aspect, the adhesion layer may include a metal or a metal oxide.

[18] In the optical laminate according to the foregoing aspect, the antifouling material may include a fluorine-based organic compound.

[19] The optical laminate according to the foregoing aspect may further include a hard coating layer that is provided between the transparent substrate and the adhesion layer.

[20] An article according to a fourth aspect of the present invention includes the optical laminate according to the foregoing aspects.

[21] A method for producing an optical laminate according to a fifth aspect of the present invention is a method for producing the optical laminate according to the foregoing aspects including an antifouling layer forming step of forming the antifouling layer including a vapor-deposited film in which an antifouling material is vapor-deposited by vacuum vapor deposition on one surface side of the optical function layer.

[22] The method for producing an optical laminate according to the foregoing aspect may further include an optical function layer forming step of forming the optical function layer by sputtering. The optical function layer forming step and the antifouling layer forming step may be consecutively performed in a decompressed state.

Effects of Invention

According to the present invention, it is possible to provide a method for producing an optical laminate including an antifouling layer having excellent durability.

BRIEF DESCRIPTION OF DRAWINGS

FIG. 1 is a cross-sectional view illustrating an example of an optical laminate of the present embodiment.
FIG. 2 is a cross-sectional view illustrating other example of the optical laminate of the present embodiment.
FIG. 3 is a cross-sectional view illustrating other example of the optical laminate of the present embodiment.
FIG. 4 is an explanatory schematic view of an example of a production apparatus which can be used in a method for producing the optical laminate of the present embodiment.

EMBODIMENTS FOR CARRYING OUT THE INVENTION

Hereinafter, the present embodiment will be described in detail suitably with reference to the drawings. In the drawings used in the following description, in order to make characteristics of the present invention easy to understand, characteristic parts may be illustrated in an enlarged manner for the sake of convenience, and dimensional ratios or the like of each constituent element may differ from actual values thereof. Materials, dimensions, and the like exemplified in the following description are examples. The present invention is not limited thereto and can be suitably changed and performed within a range exhibiting the effects thereof.

[Optical laminate]

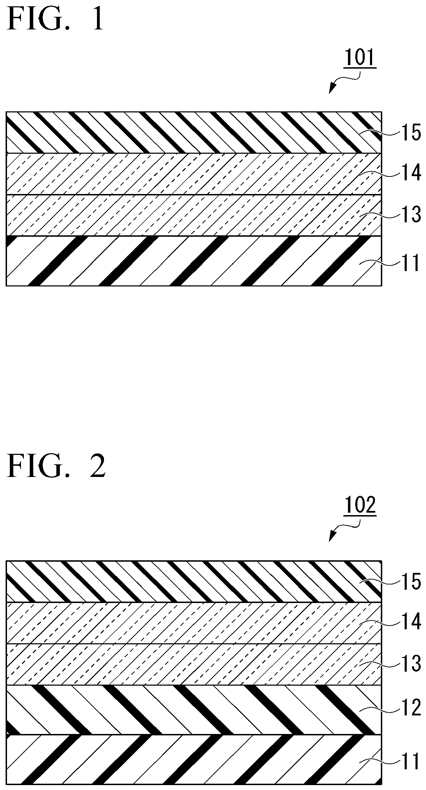

FIG. 1 is an explanatory cross-sectional view of an example of an optical laminate of the present embodiment.

As illustrated in FIG. 1, an optical laminate 101 of the present embodiment includes a transparent substrate 11, an adhesion layer 13, an optical function layer 14, and an antifouling layer 15 which are laminated in this order.

The adhesion layer 13 is a layer realizing adhesion.

The optical function layer 14 is a layer realizing an optical function. The optical function is a function of controlling reflection, transmission, and refraction which are properties of light, and examples thereof include an antireflection function, a selective reflection function, and a lens function.

It is preferable that the optical function layer 14 include any one selected from an antireflection layer and a selective reflection layer. Known layers can be used as an antireflection layer, a selective reflection layer, and an antiglare layer. All the antireflection layer, the selective reflection layer, and the antiglare layer may be single layers or laminates of a plurality of layers.

FIG. 2 is a cross-sectional view illustrating other example of the optical laminate of the present embodiment.

An optical laminate 102 illustrated in FIG. 2 includes the transparent substrate 11, a hard coating layer 12, the adhesion layer 13, the optical function layer 14, and the antifouling layer 15 which are laminated in this order.

The adhesion layer 13 is a layer realizing adhesion.

The optical function layer 14 is a layer realizing an optical function. The optical function is a function of controlling reflection, transmission, and refraction which are properties of light, and examples thereof include an antireflection function, a selective reflection function, and a lens function.

It is preferable that the optical function layer 14 include any one selected from an antireflection layer and a selective reflection layer. Known layers can be used as the antireflection layer and the selective reflection layer. Both the antireflection layer and the selective reflection layer may be single layers or laminates of a plurality of layers.

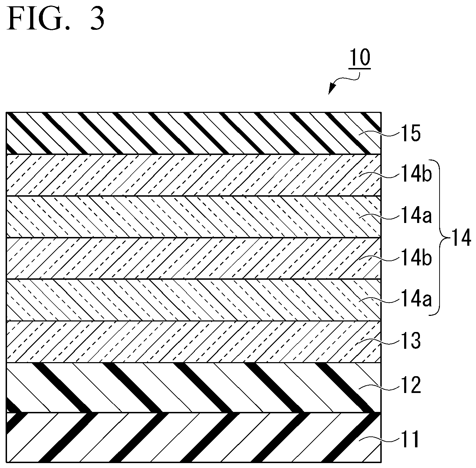

FIG. 3 is a cross-sectional view illustrating other example of the optical laminate of the present embodiment.

The optical laminate 10 illustrated in FIG. 3 is am optical laminate in which an antireflection layer is provided as the optical function layer 14 in the optical laminate 102 illustrated in FIG. 2. As illustrated in FIG. 2, the optical function layer 14 (antireflection layer) includes a laminate in which low refractive index layers 14b and high refractive index layers 14a are alternately laminated. In the optical function layer 14 illustrated in FIG. 2, the hard coating layer 12, the adhesion layer 13, the high refractive index layer 14a, the low refractive index layer 14b, the high refractive index layer 14a, the low refractive index layer 14b, and the antifouling layer 15 are sequentially laminated in this order from the transparent substrate 11 side. Therefore, the antifouling layer 15 comes into contact with the low refractive index layer 14b provided in the optical function layer 14.

The transparent substrate 11 need only be formed of a transparent material allowing light of visible light range to be transmitted therethrough. For example, a plastic film is favorably used as the transparent substrate 11. Specific examples of a constituent material of the plastic film include a polyester-based resin, an acetate-based resin, a polyether sulfone-based resin, a polycarbonate-based resin, a polyamide-based resin, a polyimide-based resin, a polyolefin-based resin, a (meth)acryl-based resin, a polyvinylchloride-based resin, a polyvinylidene chloride-based resin, a polystyrene-based resin, a polyvinyl alcohol-based resin, a polyarylate-based resin, and a polyphenylene sulfide-based resin.

The term "transparent material" mentioned in the present invention indicates a material in which a transmittance of light in a used wavelength range is 80% or higher within a range not impairing the effects of the present invention.

In addition, in the present embodiment, "(meth)acryl" denotes methacryl and acryl.

As long as optical characteristics are not significantly impaired, a reinforcement material may be included in the transparent substrate 11. Examples of the reinforcement material include cellulose nanofibers and nano-silica. Particularly, a polyester-based resin, an acetate-based resin, a polycarbonate-based resin, or a polyolefin-based resin is favorably used as the reinforcement material. Specifically, a triacetyl cellulose (TAC) base material is favorably used as the reinforcement material.

In addition, a glass film which is an inorganic base material can also be used in the transparent substrate 11.

If the plastic film is a TAC base material, when the hard coating layer 12 is formed on one surface side thereof, a part of a component constituting the hard coating layer 12 is permeated; and thereby, a permeation layer is formed. As a result, adhesive properties between the transparent substrate 11 and the hard coating layer 12 become satisfactory, and occurrence of an interference fringe caused by a difference between refractive indices of the layers can be curbed.

The transparent substrate 11 may be a film to which an optical function and/or a physical function is imparted. Examples of the film having an optical and/or physical function include a polarization plate, a phase difference compensation film, a heat-ray blocking film, a transparent conductive film, a luminance improvement film, and a barrier-property improvement film.

The thickness of the transparent substrate 11 is not particularly limited. However, for example, it is preferably 25 $\mu$m or larger. The film thickness of the transparent substrate 11 is more preferably 40 $\mu$m or larger.

If the thickness of the transparent substrate 11 is 25 $\mu$m or larger, the rigidity of the base material itself is secured, and creases are unlikely to be generated even when stress is applied to the optical laminate 10. In addition, if the thickness of the transparent substrate 11 is 25 $\mu$m or larger, even when the hard coating layer 12 is sequentially formed on the transparent substrate 11, creases are unlikely to be generated and there is little concern over production, which is preferable. If the thickness of the transparent substrate 11 is 40 $\mu$m or larger, creases are less likely to be generated, which is preferable.

When production is performed using a roll, the thickness of the transparent substrate 11 is preferably 1000 $\mu$m or smaller and is more preferably 600 $\mu$m or smaller. If the thickness of the transparent substrate 11 is 1000 $\mu$m or smaller, the optical laminate 10 in the middle of production and the optical laminate 10 after production are likely to be wound in a roll shape, so that the optical laminate 10 can be efficiently produced. In addition, if the thickness of the transparent substrate 11 is 1000 $\mu$m or smaller, it is possible to reduce the thickness and the weight of the optical laminate 10. If the thickness of the transparent substrate 11 is 600 $\mu$m or smaller, the optical laminate 10 can be more efficiently produced, and it is possible to further reduce the thickness and the weight, which is preferable.

A surface of the transparent substrate 11 may be subjected to etching treatment and/or primer treatment in advance, such as sputtering, corona discharging, ultraviolet irradiation, electron beam irradiation, chemical conversion, and oxidation. When it is subjected to such treatment in advance, adhesive properties with respect to the hard coating layer 12 formed on the transparent substrate 11 can be improved. In addition, before the hard coating layer 12 is formed on the transparent substrate 11, as necessary, it is also preferable that the surface of the transparent substrate 11 be subjected to dust removing and cleaning by subjecting the surface of the transparent substrate 11 to solution washing, ultrasonic washing, or the like.

A known layer can be used as the hard coating layer 12. The hard coating layer 12 may be formed of only a binder resin or may include a filler together with a binder resin within a range not impairing the transparency. As the filler, a filler formed of an organic substance may be used, a filler formed of an inorganic substance may be used, or a filler formed of an organic substance and an inorganic substance may be used.

It is preferable to adopt a transparent resin as the binder resin used for the hard coating layer 12, and for example, an ionizing radiation curable resin which is a resin cured by ultraviolet rays or electron beams, a thermoplastic resin, a thermosetting resin, or the like can be used.

Examples of the ionizing radiation curable resin used as the binder resin of the hard coating layer 12 include ethyl (meth)acrylate, ethylhexyl (meth)acrylate, styrene, methyl styrene, and N-vinylpyrrolidone.

In addition, examples of a compound which is an ionizing radiation curable resin having two or more unsaturated bonds include polyfunctional compounds such as trimethylolpropane tri(meth)acrylate, tripropylene glycol di(meth)acrylate, diethylene glycol di(meth)acrylate, dipropylene glycol di(meth)acrylate, pentaerythritol tri(meth)acrylate, pentaerythritol tetra(meth)acrylate, dipentaerythritol hexa(meth)acrylate, 1,6-hexanediol di(meth)acrylate, neopentyl glycol di(meth)acrylate, trimethylolpropane tri(meth)acrylate, ditrimethylolpropane tetra(meth)acrylate, dipentaerythritol penta(meth)acrylate, tripentaerythritol octa(meth)acrylate, tetrapentaerythritol deca(meth)acrylate, isocyanuric acid tri(meth)acrylate, isocyanuric acid di(meth)acrylate, polyester tri(meth)acrylate, polyester di(meth)acrylate, bisphenol di(meth)acrylate, diglycerin tetra(meth)acrylate, adamantyl di(meth)acrylate, isobornyl di(meth)acrylate, dicyclopentane di(meth)acrylate, tricyclodecane di(meth)acrylate, and ditrimethylolpropane tetra(meth)acrylate. Among these, pentaerythritol triacrylate (PETA), dipentaerythritol hexaacrylate (DPHA), or pentaerythritol tetraacrylate (PETTA) is favorably used. The notation "(meth)acrylate" indicates methacrylate and acrylate. In addition, a resin obtained by modifying the compounds described above with propylene oxide (PO), ethylene oxide (EO), caprolactone (CL), or the like can also be used as the ionizing radiation curable resin.

Examples of the thermoplastic resin used as a binder resin of the hard coating layer 12 include a styrene-based resin, a (meth)acryl-based resin, a vinyl acetate-based resin, a vinyl ether-based resin, a halogen-containing resin, an alicyclic olefin-based resin, a polycarbonate-based resin, a polyester-based resin, a polyamide-based resin, a cellulose derivative, a silicone-based resin, and rubber or an elastomer. It is preferable that the foregoing thermoplastic resins be amorphous and soluble in an organic solvent (particularly a common solvent in which a plurality of polymers and a curable compound can dissolve). Particularly, from a viewpoint of transparency and weather resistance, it is preferable to adopt a styrene-based resin, a (meth)acryl-based resin, an alicyclic olefin-based resin, a polyester-based resin, a cellulose derivative (cellulose esters or the like), or the like.

Examples of the thermosetting resin used as a binder resin of the hard coating layer 12 include a phenol resin, a urea resin, a diallyl phthalate resin, a melamine resin, a guanamine resin, an unsaturated polyester resin, a polyurethane resin, an epoxy resin, an amino alkyd resin, a melamine-urea cocondensation resin, a silicon resin, a polysiloxane resin (including so-called silsesquioxane having a cage shape, a ladder shape, or the like).

The hard coating layer 12 may include an organic resin and an inorganic material or may be formed of an organic-inorganic hybrid material. Examples thereof include a layer formed by a sol-gel method. Examples of the inorganic material include silica, alumina, zirconia, and titania. Examples of the organic material include an acrylic resin.

Regarding a filler included in the hard coating layer 12, from a viewpoint of antiglare properties, adhesive properties with respect to the optical function layer 14 which will be described below, and anti-blocking properties, various materials can be selected in accordance with the application of the optical laminate 10. Specifically, for example, known materials such as silica (Si oxide) particles, alumina (aluminum oxide) particles, and organic fine particles can be used.

For example, the hard coating layer 12 may include a binder resin, and silica particles and/or alumina particles as a filler. When silica particles and/or alumina particles are dispersed in the hard coating layer 12 as a filler, fine irregularities can be formed on a surface of the hard coating layer 12. These silica particles and/or alumina particles may be exposed to a surface of the hard coating layer 12 on the optical function layer 14 side. In this case, the binder resin of the hard coating layer 12 and the optical function layer 14 are strongly joined to each other. For this reason, the adhesive properties between the hard coating layer 12 and the optical function layer 14 are improved, the hardness of the hard coating layer 12 is enhanced, and the scratch resistance of the optical laminate 10 becomes satisfactory.

For example, the average particle size of the filler of the hard coating layer 12 is 800 nm or smaller, is preferably 780 nm or smaller, and is more preferably 100 nm or smaller. For example, silica particles, alumina particles, or the like are favorably used as a filler having the size. When the particle size of the filler is within the range, the haze value of the optical laminate 10 in its entirety becomes 2% or lower. The optical laminate 10 having a haze of 2% or lower has a high degree of transparency and becomes a so-called clear-type antireflection film.

For example, the average particle size of the filler of the hard coating layer 12 may be 0.5 $\mu$m or larger. For

example, organic fine particles such as an acrylic resin are favorably used as a filler having the size. When the particle size of the filler is within the range, the haze value of the optical laminate 10 in its entirety becomes greater than 2%. The optical laminate 10 having a haze greater than 2% has antiglare properties and becomes a so-called antiglare (AG)-type antireflection film. In this case as well, the average particle size of the filler is preferably 10 $\mu$m or smaller, is more preferably 5 $\mu$m or smaller, and is particularly preferably 3 $\mu$m or smaller.

Regarding a filler contained in the hard coating layer 12, in order to impart toughness to the hard coating layer 12, various reinforcement materials can be used within a range not impairing the optical characteristics. Examples of the reinforcement material include cellulose nanofibers.

The thickness of the hard coating layer 12 is not particularly limited. However, for example, it is preferably 0.5 $\mu$m or larger and is more preferably 1 $\mu$m or larger. The thickness of the hard coating layer 12 is preferably 100 $\mu$m or smaller. If the thickness of the hard coating layer 12 is 0.5 $\mu$m or larger, a sufficient hardness can be obtained so that scratches during production are unlikely to be generated. In addition, if the thickness of the hard coating layer 12 is 100 $\mu$m or smaller, it is possible to reduce the thickness and the weight of the optical laminate 10. In addition, if the thickness of the hard coating layer 12 is 100 $\mu$m or smaller, micro-cracking in the hard coating layer 12 occurring when the optical laminate 10 in the middle of production is bent is unlikely to occur, and thus productivity becomes satisfactory.

The hard coating layer 12 may be a single layer or a laminate of a plurality of layers. In addition, for example, a known function such as an ultraviolet absorption performance, an antistatic performance, a refractive index adjustment function, and a hardness adjustment function may further be imparted to the hard coating layer 12.

In addition, the function imparted to the hard coating layer 12 may be imparted to a single hard coating layer or may be imparted to a plurality of divided layers.

The adhesion layer 13 is a layer formed for satisfactory adhesion between the transparent substrate 11 or the hard coating layer 12 which is an organic film and the optical function layer 14 which is an inorganic film. In the optical laminate 10 illustrated in FIG. 3, the adhesion layer 13 is provided between the hard coating layer 12 and the optical function layer 14. The adhesion layer 13 has a function of adhering the hard coating layer 12 and the optical function layer 14 to each other. The adhesion layer 13 is preferably formed of a metal oxide in an oxygen deficient state or a metal. The metal oxide in an oxygen deficient state indicates a metal oxide in a state of having fewer atoms of oxygen than a stoichiometric composition. Examples of the metal oxide in an oxygen deficient state include SiOx, AlOx, TiOx, ZrOx, CeOx, MgOx, ZnOx, TaOx, SbOx, SnOx, and MnOx. In addition, Examples of the metal include Si, Al, Ti, Zr, Ce, Mg, Zn, Ta, Sb, Sn, Mn, and In. In the adhesion layer 13, for example, x in SiOx may be larger than zero and smaller than 2.0. In addition, the adhesion layer may be formed of a mixture of a plurality of kinds of metals or metal oxides.

From a viewpoint of maintaining transparency and adhesive properties with respect to the optical function layer and obtaining satisfactory optical characteristics, the thickness of the adhesion layer is preferably larger than 0 nm and 20 nm or smaller and is particularly preferably 1 nm to 10 nm.

The optical function layer 14 is a laminate realizing an antireflection function. The optical function layer 14 illustrated in FIG. 3 is a laminate having four layers in total in which the high refractive index layers 14a and the low refractive index layers 14b are alternately laminated sequentially from the adhesion layer 13 side. The number of layers of the high refractive index layers 14a and the low refractive index layers 14b is not particularly limited, and the number of layers of the high refractive index layers 14a and the low refractive index layers 14b can be an arbitrary number of layers.

In the optical laminate 10 illustrated in FIG. 3, since the optical function layer 14 includes a laminate in which the low refractive index layers 14b and the high refractive index layers 14a are alternately laminated, light incident from the antifouling layer 15 side is diffused by the optical function layer 14. Therefore, it is possible to obtain the antireflection function of preventing light incident from the antifouling layer 15 side from being reflected in one direction.

For example, the low refractive index layers 14b include a metal oxide. The low refractive index layers 14b may include Si oxide in regard to availability and costs and is preferably a layer having $SiO_2$ (Si oxide) or the like as a main component. A single layer film of $SiO_2$ is colorless and transparent. In the present embodiment, a main component of the low refractive index layers 14b denotes a component included in the low refractive index layers 14b in an amount of 50 mass% or more.

When the low refractive index layers 14b are layers having Si oxide as a main component, it may include a different element in an amount less than 50 mass%. The content of an element different from Si oxide is preferably 10% or lower. As the different element, for example, it is possible to contain Na for the purpose of improving the durability, Zr, Al, or N for the purpose of improving the hardness, and Zr and Al for the purpose of improving the alkali resistance.

The refractive index of the low refractive index layers 14b is preferably 1.20 to 1.60 and is more preferably 1.30 to 1.50. Examples of a dielectric used in the low refractive index layers 14b include magnesium fluoride ($MgF_2$, a refractive index of 1.38).

The refractive index of the high refractive index layers 14a is preferably 2.00 to 2.60 and is more preferably 2.10 to 2.45. Examples of a dielectric used in the high refractive index layers 14a include niobium pentoxide ($Nb_2O_5$, a refractive index of 2.33), titanium oxide ($TiO_2$, a refractive index of 2.33 to 2.55), tungsten oxide ($WO_3$, a refractive index of 2.2), cerium oxide ($CeO_2$, a refractive index of 2.2), tantalum pentoxide ($TazOs$, a refractive index of 2.16), zinc oxide (ZnO, a refractive index of 2.1), indium tin oxide (ITO, a refractive index of 2.06), and zirconium oxide (ZrOz, a refractive index of 2.2).

When it is intended to impart conductive characteristics to the high refractive index layers 14a, for example, ITO or indium oxide zinc oxide (IZO) can be selected.

In the optical function layer 14, for example, it is preferable to use layers formed of niobium pentoxide ($Nb_2O_5$, a refractive index of 2.33) as the high refractive index layers 14a and use layers formed of $SiO_2$ as the low refractive index layers 14b.

The film thickness of the low refractive index layers 14b need only be within a range of 1 nm to 200 nm and is suitably selected in accordance with the wavelength range requiring an antireflection function.

For example, the film thickness of the high refractive index layers 14a need only be 1 nm to 200 nm and is suitably selected in accordance with the wavelength range requiring an antireflection function.

Each film thickness of the high refractive index layers 14a and the low refractive index layers 14b can be suitably selected in accordance with the design of the optical function layer 14.

For example, it is possible to include the high refractive index layer 14a of 5 to 50 nm, the low refractive index layer 14b of 10 to 80 nm, the high refractive index layer 14a of 20 to 200 nm, and the low refractive index layer 14b of 50 to 200 nm sequentially from the adhesion layer 13 side.

In the layers forming the optical function layer 14, the low refractive index layers 14b are disposed on the antifouling layer 15 side. When the low refractive index layer 14b of the optical function layer 14 comes into contact with the antifouling layer 15, the antireflection performance of the optical function layer 14 becomes satisfactory, which is preferable.

The antifouling layer 15 is formed on the outermost surface of the optical function layer 14 and prevents fouling of the optical function layer 14. In addition, when the antifouling layer 15 is applied to a touch panel or the like, wear of the optical function layer 14 is curbed due to the wear resistance thereof.

For example, the antifouling layer 15 of the present embodiment includes a vapor-deposited film in which an antifouling material is vapor-deposited. In the present embodiment, the antifouling layer 15 is formed on one surface of the low refractive index layer 14b constituting the optical function layer 14 by performing vacuum vapor deposition of a fluorine-based organic compound as an antifouling material. In the present embodiment, since the antifouling material includes a fluorine-based organic compound, the optical laminate 10 having more satisfactory friction resistance and alkali resistance is obtained.

As the fluorine-based organic compound constituting the antifouling layer 15, a compound including a fluorine-modified organic group and a reactive silyl group (for example, alkoxysilane) is preferably used. Commercially available products include OPTOOL DSX (manufactured by DAIKIN INDUSTRIES, LTD.) and KY-100 Series (manufactured by SHIN-ETSU CHEMICAL CO., LTD.).

When a compound including a fluorine-modified organic group and a reactive silyl group (for example, alkoxysilane) is used as the fluorine-based organic compound constituting the antifouling layer 15, and a layer formed of $SiO_2$ is used as the low refractive index layer 14b of the optical function layer 14 which comes into contact with the antifouling layer 15, siloxane bonds are formed between silanol groups which form a skeleton of the fluorine-based organic compound and $SiO_2$. For this reason, the adhesive properties between the optical function layer 14 and the antifouling layer 15 become satisfactory, which is preferable.

The optical thickness of the antifouling layer 15 need only be within a range of 1 nm to 20 nm and is preferably within a range of 3 nm to 10 nm. If the thickness of the antifouling layer 15 is 1 nm or larger, when the optical laminate 10 is applied to applications of a touch panel or the like, wear resistance can be sufficiently secured. In addition, if the thickness of the antifouling layer 15 is 20 nm or smaller, a time required for vapor deposition is shortened, and it can be efficiently produced.

A surface roughness Ra of the antifouling layer 15 varies depending on the purpose or the constitution of the optical laminate. For example, when the optical laminate is a transparent antireflection layer having no antiglare function (clear-type antireflection film), for example, the surface roughness Ra of the antifouling layer 15 is preferably 3 nm or larger. The upper limit therefor is not particularly limited. However, for example, it is preferably 9 nm or smaller in regard to scratch resistance. On the other hand, when the optical laminate is an antireflection layer having an antiglare function (AG-type antireflection film), for example, the surface roughness Ra of the antifouling layer 15 is preferably 10 nm or larger and is more preferably 30 nm or larger. The surface roughness Ra of the antifouling layer 15 is a value before a scratch resistance test is performed.

An average length RSm of the elements of the antifouling layer 15 varies depending on the purpose or the constitution of the optical laminate. For example, when the optical laminate is an antireflection layer having an antiglare function (AG-type antireflection film), the average length RSm of the elements of the antifouling layer 15 is preferably 59 nm or larger and is more preferably 92 nm or smaller. The average length RSm of the elements of the antifouling layer 15 is a value before a scratch resistance test is performed.

As necessary, the antifouling layer 15 may include an additive such as a light stabilizer, an ultraviolet ray absorbent, a colorant, an antistatic agent, a lubricant, a leveling agent, a defoamer, an antioxidant, a flame retardant, an infrared ray absorbent, or a surfactant.

The antifouling layer 15 formed by vapor deposition is firmly bonded to the optical function layer 14 and the antifouling layer 15 has few voids and is dense. Accordingly, the antifouling layer 15 of the present embodiment exhibits characteristics different from those of an antifouling layer formed by a method in the related art, such as coating of an antifouling material.

For example, the antifouling layer 15 of the clear-type optical laminate 10 of the present embodiment has the following characteristics.

(1) A contact angle difference with respect to water after a scratch test of 500 times of horizontal reciprocating motion with steel wool is 12° or smaller.

(2) A contact angle with respect to water after a scratch test of 500 times of horizontal reciprocating motion with steel wool is 109° or larger.

(3) A contact angle with respect to water after a scratch test in which a waste cloth (nonwoven fabric wiper) is reciprocated 4000 times is 108° or larger.

(4) An amount of change in L*a*b* value (ΔE value) indicated by the following Expression (3) by specular component included (SCI, a method for measuring reflected color taking specular reflection light into consideration) before and after a scratch test of 500 times of horizontal reciprocating motion with steel wool is 3.0 or smaller.

$$\Delta E = \Delta(L^*a^*b^*) = \sqrt{(L1^* - L0^*)^2 + (a1^* - a0^*)^2 + (b1^* - b0^*)^2} \quad \cdots \text{Expression (3)}$$

(in Expression (3), L0*, a0*, and b0* are values before a scratch test, and L1*, a1*, and b1* are values after the scratch test)

(5) An amount of change in L*a*b* value (ΔE value) indicated by the following Expression (4) by specular component excluded (SCE, a method for measuring reflected color not taking specular reflection light into consideration) before and after a scratch test of 500 times of horizontal reciprocating motion with steel wool is 0.5 or smaller.

$$\Delta E = \Delta(L^*a^*b^*) = \sqrt{(L1^* - L0^*)^2 + (a1^* - a0^*)^2 + (b1^* - b0^*)^2} \quad \cdots \text{Expression (4)}$$

(in Expression (4), L0*, a0*, and b0* are values before a scratch test, and L1*, a1*, and b1* are values after the scratch test)

(6) A residual ratio of fluorine measured by an X-ray fluorescence analysis method (XRF) after immersion in a NaOH solution (liquid temperature of 55°C) having a concentration of 0.1 mol/L for four hours is 70% or higher.

(7) A residual ratio of fluorine measured by an X-ray fluorescence analysis method (XRF) after an ultrasonic washing test is 79% or higher.

In addition, for example, the antifouling layer 15 of the AG-type optical laminate 10 of the present embodiment has the following characteristics.

(1) A residual ratio of fluorine measured by electron spectroscopy for chemical analysis (ESCA) after a scratch test in which a waste cloth (nonwoven fabric wiper) is reciprocated 4000 times is 78% or higher.

(2) A residual ratio of fluorine measured by an X-ray fluorescence analysis method (XRF) after immersion in a NaOH solution (liquid temperature of 55°C) having a concentration of 0.1 mol/L for four hours is 90% or higher.

(3) A residual ratio of fluorine measured by an X-ray fluorescence analysis method (XRF) after an ultrasonic washing test is 77% or higher.

The optical laminate 10 including the antifouling layer 15 of the present embodiment formed by vapor deposition is formed to have fewer voids and be dense than an antifouling layer formed by coating. In addition, in the optical laminate 10 of the present embodiment, the antifouling layer 15 is firmly bonded to the low refractive index layer 14b which comes into contact with the antifouling layer 15. Therefore, the optical laminate 10 of the present embodiment has excellent visible light transmission properties, can maintain high wear resistance with respect to repeated friction, and can also maintain high resistance with respect to alkali resistance.

[Method for producing optical laminate]

For example, the optical laminate 10 of the present embodiment illustrated in FIG. 3 can be produced by the method described below.

In the present embodiment, as an example of the method for producing the optical laminate 10, a case in which the optical laminate 10 is produced using the transparent substrate 11 wound in a roll shape will be described as an example.

First, the transparent substrate 11 wound in a roll shape is unwound. Further, a slurry including a material for forming the hard coating layer 12 is coated on the transparent substrate 11 by a known method and is cured by a known method suitable for the material for forming the hard coating layer 12. In this manner, the hard coating layer 12 is formed (hard coating layer forming step). Thereafter, the transparent substrate 11 having the hard coating layer 12 formed on a surface thereof is wound in a roll shape by a known method.

Next, the hard coating layer 12 is subjected to an adhesion layer forming step of forming the adhesion layer 13 and an optical function layer forming step of forming the optical function layer 14 are performed. Thereafter, an antifouling layer forming step of forming the antifouling layer 15 on the optical function layer 14. In the present embodiment, it is preferable to perform a first surface treatment step of performing treatment of the surface of the hard coating layer 12 before the optical function layer forming step and perform the adhesion layer forming step and the optical function layer forming step thereafter. In addition, in the present embodiment, it is preferable to perform a second surface treatment step of performing treatment of the surface of the optical function layer 14 after the optical function layer forming step and perform the antifouling layer forming step thereafter.

In the method for producing the optical laminate 10 of the present embodiment, it is preferable to consecutively perform the first surface treatment step, the adhesion layer forming step, the optical function layer forming step, the second surface treatment step, and the antifouling layer forming step while the optical laminate in the middle of production is maintained in a decompressed state. When the first surface treatment step, the adhesion layer forming step, the optical function layer forming step, the second surface treatment step, and the antifouling layer forming step are consecutively performed while the optical laminate in the middle of production is maintained in a decompressed state, for example, it is possible to use an apparatus or the like including a thin film forming apparatus disclosed in Patent Document 4 as a sputtering apparatus.

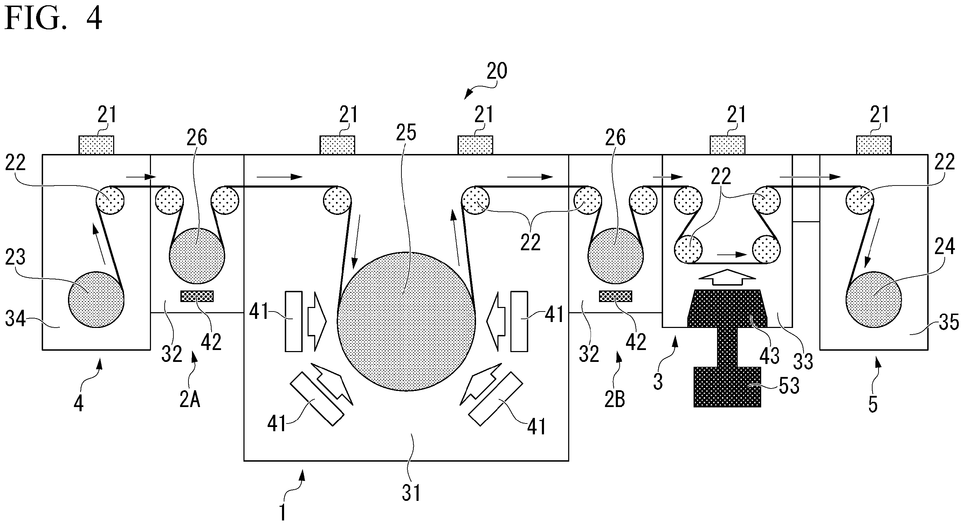

Specific examples of a production apparatus which can be used in the method for producing an optical laminate of the present embodiment include a production apparatus 20 illustrated in FIG. 4.

The production apparatus 20 illustrated in FIG. 4 includes a roll unwinding apparatus 4, a pretreatment apparatus 2A, a sputtering apparatus 1, a pretreatment apparatus 2B, a vapor deposition apparatus 3, and a roll winding apparatus 5. As illustrated in FIG. 4, these apparatuses 4, 2A, 1, 2B, 3, and 5 are connected to each other in this order. The production apparatus 20 illustrated in FIG. 4 is a roll-to-roll production apparatus which consecutively forms a plurality of layers on a base material by unwinding the base material from a roll and winding the base material which has consecutively passed through the connected apparatuses (in FIG. 4, the pretreatment apparatus 2A, the sputtering apparatus 1, the pretreatment apparatus 2B, and the vapor deposition apparatus 3).

When the optical laminate 10 is produced using a roll-to-roll production apparatus, the conveyance speed (line speed) of the optical laminate 10 in the middle of production can be suitably set. For example, the conveyance speed is preferably set to 0.5 to 20 m/min and is more preferably set to 0.5 to 10 m/min.

<Roll unwinding apparatus>

The roll unwinding apparatus 4 illustrated in FIG. 4 includes a chamber 34 internally having a predetermined decompressed atmosphere, one or a plurality of vacuum pumps 21 (one in FIG. 4) for discharging gas inside the chamber 34 to realize a decompressed atmosphere, and an unwinding roll 23 and a guide roll 22 installed inside the chamber 34. As illustrated in FIG. 4, the chamber 34 is connected to a chamber 31 of the sputtering apparatus 1 via the pretreatment apparatus 2A.

The transparent substrate 11 having the hard coating layer 12 formed on a surface thereof is wound around the unwinding roll 23. The unwinding roll 23 supplies the transparent substrate 11 having the hard coating layer 12 formed on a surface thereof to the pretreatment apparatus 2A at a predetermined conveyance speed.

<Pretreatment apparatus 2A>

The pretreatment apparatus 2A illustrated in FIG. 4 includes a chamber 32 internally having a predetermined decompressed atmosphere, a can roll 26, a plurality of (two in FIG. 4) guide rolls 22, and a plasma discharge apparatus 42. As illustrated in FIG. 4, the can roll 26, the guide rolls 22, and the plasma discharge apparatus 42 are installed inside the chamber 32. As illustrated in FIG. 4, the chamber 32 is connected to the chamber 31 of the sputtering apparatus 1.

The can roll 26 and the guide rolls 22 convey the transparent substrate 11 which is sent from the roll unwinding apparatus 4 and has the hard coating layer 12 formed thereon at a predetermined conveyance speed and send out the transparent substrate 11 having a treated surface of the hard coating layer 12 to the sputtering apparatus 1.

As illustrated in FIG. 4, the plasma discharge apparatus 42 is disposed such that it faces an outer circumferential surface of the can roll 26 in a separated manner with a predetermined gap therebetween. The plasma discharge apparatus 42 ionizes gas by glow discharging. It is preferable to adopt gas which is inexpensive and inert and does not affect the optical characteristics. For example, argon gas, oxygen gas, nitrogen gas, helium gas, or the like can be used. As the gas, it is preferable to use argon gas because it has a large mass, is chemically stable, and is readily available.

In the present embodiment, as the plasma discharge apparatus 42, it is preferable to use a glow discharging apparatus for ionizing argon gas by high-frequency plasma.

<Sputtering apparatus>

The sputtering apparatus 1 illustrated in FIG. 4 includes the chamber 31 internally having a predetermined decompressed atmosphere, one or a plurality of vacuum pumps 21 (two in FIG. 4) for discharging gas inside the chamber 31 to realize a decompressed atmosphere, a film formation roll 25, a plurality of (two in FIG. 4) guide rolls 22, and a plurality of (four in the example illustrated in FIG. 4) film formation portions 41. As illustrated in FIG. 4, the film formation roll 25, the guide rolls 22, and the film formation portions 41 are installed inside the chamber 31. As illustrated in FIG. 4, the chamber 31 is connected to the chamber 32 of the pretreatment apparatus 2B.

The film formation roll 25 and the guide rolls 22 convey the transparent substrate 11 which is sent from the pretreatment apparatus 2A and has the hard coating layer 12 formed thereon with a treated surface at a predetermined conveyance speed, and supply the transparent substrate 11 having the adhesion layer 13 and the optical function layer 14 formed on the hard coating layer 12 to the pretreatment apparatus 2B.

In the sputtering apparatus 1 illustrated in FIG. 4, the adhesion layer 13 is laminated on the hard coating layer 12 of the transparent substrate 11 traveling on the film formation roll 25 by sputtering, the high refractive index layers 14a and the low refractive index layers 14b are alternately laminated thereon; and thereby, the optical function layer 14 is formed.

As illustrated in FIG. 4, the film formation portions 41 are disposed such that they face an outer circumferential surface of the film formation roll 25 in a separated manner with a predetermined gap therebetween, and a plurality of film formation portions are provided such that the film formation roll 25 is surrounded. The number of film formation portions 41 is determined in accordance with the total number of laminates of the adhesion layer 13 and the high refractive index layers 14a and the low refractive index layers 14b which form the optical function layer 14. When a distance between adjacent film formation portions 41 is unlikely to be secured due to the large number of total laminates of the adhesion layer 13 and the high refractive index layers 14a and the low refractive index layers 14b which form the optical function layer 14, a plurality of film formation rolls 25 may be provided inside the chamber 31 and the film formation portions 41 may be disposed around the respective film formation rolls 25. When a plurality of film formation rolls 25 are provided, the guide rolls 22 may be further installed as necessary. A plurality of chambers 31 provided with the film formation roll 25 and the film formation portion 41 may be connected to each other. In addition, the diameter of the film formation roll 25 may be suitably varied in order to easily secure a distance between adjacent film formation portions 41.

A predetermined target (not illustrated) is individually installed in each of the film formation portions 41. A voltage is applied to the target by a known structure. In the present embodiment, a gas supply portion (not illustrated) for supplying predetermined reactive gas and carrier gas to the target at a predetermined flow rate and a known magnetic field generation source (not illustrated) for forming a magnetic field on a surface of the target are provided in the vicinity of the target.

The material of the target and the kind and the flow rate of the reactive gas are suitably determined in accordance with compositions of the adhesion layer 13, the high refractive index layers 14a, and the low refractive index layers 14b which are formed on the transparent substrate 11 after passing through between the film formation portions 41 and the film formation roll 25. For example, when a layer consisting of $SiO_z$ is formed, Si is used as a target, and $O_2$ is used as reactive gas. In addition, for example, when a layer consisting of $Nb_2O_5$ is formed, Nb is used as a target, and $O_2$ is used as reactive gas.

In the present embodiment, from a viewpoint of increasing a film formation speed, it is preferable to use a magnetron sputtering method as a sputtering method.

The sputtering method is not limited to the magnetron sputtering method, and a two-pole sputtering type utilizing plasma generated by DC glow discharging or a high frequency, a three-pole sputtering type applying a hot cathode, or the like may be used.

The sputtering apparatus 1 includes an optical monitor (not illustrated) serving as a measurement unit measuring optical characteristics after film formation of each of the layers which will become the adhesion layer 13 and the optical function layer 14. Accordingly, the quality of the adhesion layer 13 and the optical function layer 14 which have been formed can be checked. For example, when the sputtering apparatus 1 has two or more chambers, it is preferable to install an optical monitor inside each chamber.

Examples of the optical monitor (not illustrated) include an element measuring optical characteristics in the width direction of the adhesion layer 13 and the optical function layer 14 formed on the hard coating layer 12 using an optical head which can perform scanning in the width direction. When such an optical monitor is provided, for example, it is possible to measure a peak wavelength of the reflectance as optical characteristics and to measure a distribution of optical thicknesses of the adhesion layer 13 and the optical function layer 14 in the width direction by converting the measured peak wavelength into an optical thickness. The optical laminate 10 including the adhesion layer 13 and the optical function layer 14 having optimum optical characteristics can be formed while sputtering conditions are adjusted in real time by measuring optical characteristics using the optical monitor.

<Pretreatment apparatus 2B>

The pretreatment apparatus 2B illustrated in FIG. 4 includes a chamber 32 internally having a predetermined decompressed atmosphere, a can roll 26, a plurality of (two in FIG. 4) guide rolls 22, and a plasma discharge apparatus 42. As illustrated in FIG. 4, the can roll 26, the guide rolls 22, and the plasma discharge apparatus 42 are installed inside the chamber 32. As illustrated in FIG. 4, the chamber 32 is connected to a chamber 33 of the vapor deposition apparatus 3.

The can roll 26 and the guide rolls 22 convey the transparent substrate 11 sent from the sputtering apparatus 1 and having each of the layers formed thereon up to the optical function layer 14 at a predetermined conveyance speed and send out the transparent substrate 11 having the optical function layer 14 with a treated surface to the vapor deposition apparatus 3.

As the plasma discharge apparatus 42, for example, an apparatus similar to the pretreatment apparatus 2A can be used. The plasma discharge apparatus 42 ionizes gas by glow discharging. It is preferable to adopt gas which is inexpensive and inert and does not affect the optical characteristics. For example, argon gas, oxygen gas, nitrogen gas, helium gas, or the like can be used. Argon gas or oxygen gas significantly affects the surface of the optical function layer 14. Particularly, when argon gas having a large mass is used, the surface roughness Ra or the average length RSm of the elements of the optical function layer 14 is likely to be adjusted.

<Vapor deposition apparatus>

The vapor deposition apparatus 3 illustrated in FIG. 4 includes the chamber 33 internally having a predetermined decompressed atmosphere, one or a plurality of vacuum pumps 21 (one in FIG. 4) for discharging gas inside the chamber 33 to realize a decompressed atmosphere, a plurality of (four in FIG. 4) guide rolls 22, a vapor deposition source 43, and a heating apparatus 53. As illustrated in FIG. 4, the guide rolls 22 and the vapor deposition source 43 are installed inside the chamber 33. The chamber 33 is connected to a chamber 35 of the roll winding apparatus 5.

The vapor deposition source 43 is disposed such that it faces the transparent substrate 11 which has the optical function layer 14 with a treated surface and is conveyed substantially in a horizontal manner between two adjacent guide rolls 22. The vapor deposition source 43 supplies vaporized gas consisting of a material which will become the antifouling layer 15 onto the optical function layer 14. The direction of the vapor deposition source 43 can be arbitrarily set.

The heating apparatus 53 heats the material which will become the antifouling layer 15 to a steam pressure temperature. As the heating apparatus 53, a heating apparatus of a resistance heating type, a heater heating type, an induction heating type, an electron beam type, or the like can be used. In the resistance heating type, electrification heating is performed using a container accommodating an antifouling material which will become the antifouling layer 15 as a resistor. In the heater heating type, a container is heated by a heater disposed at the outer circumference of the container. In the induction heating type, a container or an antifouling material is heated due to electromagnetic induction action from an induction coil installed outside.

The vapor deposition apparatus 3 illustrated in FIG. 4 includes a guide plate (not illustrated) for guiding a vapor deposition material vaporized by the vapor deposition source 43 to a predetermined position, a film thickness meter (not illustrated) for observing the thickness of the antifouling layer 15 formed by vapor deposition, a vacuum pressure gauge (not illustrated) for measuring the pressure inside the chamber 33, and a power supply device (not illustrated).

The guide plate may have any shape as long as a vaporized vapor deposition material can be guided to a desired position. The guide plate may not be provided if it is not necessary.

For example, an ion gauge or the like can be used as the vacuum pressure gauge.

Examples of the power supply device include a high-frequency power supply.

<Roll winding apparatus>

The roll winding apparatus 5 illustrated in FIG. 4 includes the chamber 35 internally having a predetermined decompressed atmosphere, one or a plurality of vacuum pumps 21 (one in FIG. 4) for discharging gas inside the chamber 35 to realize a decompressed atmosphere, and a winding roll 24 and guide rolls 22 installed inside the chamber 35.

The transparent substrate 11 (optical laminate 10) having each of the layers formed on the surface thereof up to the antifouling layer 15 is wound around the winding roll 24. The winding roll 24 and the guide rolls 22 wind the optical laminate 10 at a predetermined winding speed.

As necessary, a carrier film may also be used.

As the vacuum pump 21 included in the production apparatus 20 illustrated in FIG. 4, for example, a dry pump, an oil rotary pump, a turbomolecular pump, an oil diffusion pump, a cryopump, a sputter ion pump, a getter pump, or the like can be used. The vacuum pump 21 can be suitably selected in order to make a desired decompressed state in each of the chambers 31, 32, 33, 34, and 35 or can be used in combination.

The vacuum pump 21 need only be able to maintain both the chamber 31 of the sputtering apparatus 1 and the chamber 33 of the vapor deposition apparatus 3 in a desired decompressed state, and installation positions and the number of vacuum pumps 21 in the production apparatus 20 are not particularly limited. In addition, in the production apparatus 20 illustrated in FIG. 4, the roll unwinding apparatus 4, the pretreatment apparatus 2A, the sputtering apparatus 1, the pretreatment apparatus 2B, the vapor deposition apparatus 3, and the roll winding apparatus 5 are connected. For this reason, the vacuum pump 21 may be installed in each of the chambers 31, 32, 33, 34, and 35 or may be installed in only some chambers of the chambers 31, 32, 33, 34, and 35 as long as both the chamber 31 of the sputtering apparatus 1 and the chamber 33 of the vapor deposition apparatus 3 can be maintained in a desired decompressed state.

Next, a method for consecutively performing the first surface treatment step, the adhesion layer forming step, the optical function layer forming step, the second surface treatment step, and the antifouling layer forming step while the optical laminate 10 in the middle of production is maintained in a decompressed state using the production apparatus 20 illustrated in FIG. 4 will be described.

First, the unwinding roll 23, around which the transparent substrate 11 having the hard coating layer 12 formed on a surface thereof is wound, is installed inside the chamber 34 of the roll unwinding apparatus 4. Further, the transparent substrate 11 having the hard coating layer 12 formed on a surface thereof is sent out to the pretreatment apparatus 2A at a predetermined conveyance speed by rotating the unwinding roll 23 and the guide rolls 22.

Next, the first surface treatment step is performed inside the chamber 32 of the pretreatment apparatus 2A as pretreatment with respect to the surface on which the adhesion layer 13 and the optical function layer 14 will be formed. In the present embodiment, the first surface treatment step is performed on the transparent substrate 11 having the hard coating layer 12 formed thereon.

In the first surface treatment step, the surface of the hard coating layer 12 traveling on the can roll 26 is subjected to treatment while the transparent substrate 11 having the hard coating layer 12 formed thereon is conveyed at a predetermined conveyance speed by rotating the can roll 26 and the guide rolls 22.

As a method for performing surface treatment of the hard coating layer 12, for example, glow discharge treatment, plasma treatment, ion etching, alkaline treatment, or the like can be used. Among these, it is preferable to use glow discharge treatment because a large area can be treated. For example, glow discharge treatment can be performed with a treatment strength of 0.1 to 10 kwh.

When glow discharge treatment is performed on the surface of the hard coating layer 12, the surface of the hard coating layer 12 is roughened at a nano level, and substances which are present on the surface of the hard coating layer 12 and have a weak bonding strength are removed. As a result, adhesive properties between the hard coating layer 12 and the optical function layer 14 formed on the hard coating layer 12 become satisfactory.

Next, the adhesion layer forming step and the optical function layer forming step are performed inside the chamber 31 of the sputtering apparatus 1. Specifically, the adhesion layer 13 and the optical function layer 14 are formed on the hard coating layer 12 traveling on the film formation roll 25 while the transparent substrate 11 having the hard coating layer 12 formed thereon is conveyed at a predetermined conveyance speed by rotating the film formation roll 25 and the guide rolls 22.

In the present embodiment, the adhesion layer 13 is formed and the high refractive index layers 14a and the low refractive index layers 14b are alternately laminated thereon through sputtering by varying the material of a target installed in each of the film formation portions 41 or the kind and the flow rate of the reactive gas supplied from the gas supply portion. That is, the adhesion layer forming step and the optical function layer forming step are consecutively performed inside the sputtering apparatus 1. In this manner, the adhesion layer 13 and the optical function layer 14 which is an antireflection layer are formed.

When a SiOx film is formed as the adhesion layer 13, it is preferable to perform film formation by reactive sputtering in a mixed gas atmosphere of oxygen gas and argon gas using a silicon target.

When the adhesion layer 13, the high refractive index layers 14a, and the low refractive index layers 14b are consecutively laminated by sputtering, film formation may be performed by varying the material of the target for each of the time of film formation of the adhesion layer 13, the time of film formation of the high refractive index layers 14a, and the time of film formation of the low refractive index layers 14b. In addition, for example, a layer formed of a target material and a layer formed of an oxide of a target material may be alternately formed as the adhesion layer 13, the high refractive index layers 14a, and the low refractive index layers 14b by varying the flow rate of oxygen (reactive gas) at the time of sputtering using one material as a target.

The pressure at the time of sputtering for forming the adhesion layer 13 and the optical function layer 14 varies depending on a sputtering metal. The pressure may be 2 Pa or lower, is preferably 1 Pa or lower, is more preferably 0.6 Pa or lower, and is particularly preferably 0.2 Pa or lower. If the pressure at the time of sputtering is in a decompressed state of 1 Pa or lower, the mean free path of film formation molecules is lengthened and the layers are laminated while the energy of film formation molecules is high; and thereby, a dense film having more satisfactory quality is obtained.

Thereafter, the transparent substrate 11 having the adhesion layer 13 and the optical function layer 14 formed on the hard coating layer 12 is sent out to the pretreatment apparatus 2B by the rotation of the film formation roll 25 and the guide rolls 22.

Next, the second surface treatment step is performed inside the chamber 32 of the pretreatment apparatus 2B as pretreatment with respect to the surface on which the antifouling layer 15 will be formed. In the present embodiment, the second surface treatment step is continuously performed while a decompressed state is maintained without bringing the transparent substrate 11 having the optical function layer 14, which has been obtained through the optical function layer forming step, into contact with atmospheric air.

In the second surface treatment step, discharge treatment is performed on the surface of the optical function layer 14 traveling on the can roll 26 while the transparent substrate 11 having each of the layers formed thereon up to the optical function layer 14 is conveyed at a predetermined conveyance speed by rotating the can roll 26 and the guide rolls 22.

As the method for performing surface treatment of the optical function layer 14, for example, glow discharge treatment, plasma treatment, ion etching, alkaline treatment, or the like can be used. Among these, it is preferable to use glow discharge treatment because a large area can be treated. It is preferable to perform glow discharge treatment under an atmosphere of $O_2$ gas or argon gas. When such gas is used, the surface roughness of the optical function layer 14 is easily adjusted.

When discharge treatment is performed on the surface of the optical function layer 14, the surface of the optical function layer 14 is etched, and the surface roughness of the optical function layer 14 changes. The surface roughness Ra of the optical function layer 14 can be controlled by setting the integrated output during discharge treatment within an appropriate range. The integrated output during discharge treatment is 130 W·min/m² to 2000 W·min/m². In the present embodiment, the integrated output is a value obtained by dividing the product of an output and an irradiation time of glow discharge for irradiation to the optical function layer 14 during discharge treatment by unit area.

Conditions for discharge treatment can be suitably set. The adhesive properties between the optical function layer 14 and the antifouling layer 15 formed thereon become satisfactory and the optical laminate 10 having more satisfactory friction resistance and alkali resistance can be obtained by appropriately setting the conditions for discharge treatment.

The surface roughness Ra and the average length RSm of the elements of the optical function layer 14 after discharge treatment varies depending on the surface roughness and the average length of the elements of the hard coating layer 12 provided below the optical function layer 14.

In addition, the surface roughness Ra and the average length RSm of the elements of the optical function layer 14 after discharge treatment affect the surface roughness Ra and the average length RSm of the elements of the antifouling layer 15 formed on the optical function layer 14.

In the second surface treatment step, the surface of the optical function layer is treated such that the rate of change in surface roughness expressed by the following Expression (1) becomes 1% to 25%. Particularly in a case of a clear-type antireflection film, the surface of the optical function layer is treated under this condition. For example, the integrated output during discharge treatment is one of parameters affecting the rate of change in surface roughness.

$$\text{Rate of change in surface roughness } (\%) = ((Ra2/Ra1)-1) \times 100 \ (\%) \ ... \ \text{Expression}$$

$$(1)$$

(in Expression (1), Ra1 indicates the surface roughness (Ra) of the optical function layer before surface treatment, and Ra2 indicates the surface roughness (Ra) of the optical function layer after surface treatment)

The second surface treatment step is preferably performed such that the rate of change in surface roughness expressed by Expression (1) becomes 5% to 25%, is more preferably performed such that it becomes 8% to 25%, is much more preferably performed such that it becomes 8% to 20%, is still more preferably performed such that it becomes 8% to 15%, and is yet more preferably performed such that it becomes 10% to 14%. If the rate of change in surface roughness expressed by Expression (1) is 1% or higher, the effect of improving the adhesive properties between the optical function layer 14 and the antifouling layer 15 achieved by performing the second surface treatment step becomes remarkable. In addition, if the rate of change in surface roughness expressed by Expression (1) is 25% or lower, the thickness of the optical function layer 14 is appropriate, and therefore the antifouling layer 15 having a uniform thickness is formed on the optical function layer 14.

In addition, in the second surface treatment step, the surface of the optical function layer is treated such that the rate of change in average length of the elements expressed by the following Expression (2) becomes 7 to 65%. Particularly in a case of an AG-type antireflection film, the surface of the optical function layer is treated under this condition. For example, the integrated output during discharge treatment is one of parameters affecting the average length of elements.

$$\text{Rate of change in average length of elements (\%)} = ((RSm2/RSm1)-1)\times 100 \ (\%) \ ...$$

Expression (2)

(in Expression (2), RSm1 indicates the average length (RSm) of the elements of the optical function layer before surface treatment, and RSm2 indicates the average length (RSm) of the elements of the optical function layer after surface treatment)

The second surface treatment step is preferably performed such that the rate of change in average length (RSm) of the elements expressed by Expression (2) becomes 11% to 62%, is more preferably performed such that it becomes 11% to 45%, and is much more preferably performed such that it becomes 11% to 17%. When the rate of change in average length of the elements expressed by Expression (2) is within the foregoing range, the effect of improving the adhesive properties between the optical function layer 14 and the antifouling layer 15 by performing the second surface treatment step becomes remarkable. In addition, when the rate of change in average length of the elements expressed by Expression (2) is equal to or smaller than a predetermined value, the thickness of the optical function layer 14 is appropriate, and therefore, the antifouling layer 15 having a uniform thickness is formed on the optical function layer 14.

In the present embodiment, the surface roughness (Ra) of the optical function layer 14 can be measured by the method described below. The surface roughness Ra in a surface area of 1 $\mu m^2$ of the surface of the optical function layer 14 is measured using an atomic force microscope (AFM). The surface roughness (Ra) is measured in accordance with JIS B0601 (ISO 4287). In addition, the average length (RSm) of the elements is measured in a surface area of 0.5 $\mu m^2$ of the surface of the optical function layer 14 using an atomic force microscope. The average length (RSm) of elements is also measured in accordance with JIS B0601 (ISO 4287).

Thereafter, the transparent substrate 11 having the optical function layer 14 with a treated surface is sent out to the vapor deposition apparatus 3 by the rotation of the can roll 26 and the guide rolls 22.

Next, the antifouling layer forming step is performed inside the chamber 33 of the vapor deposition apparatus 3. In the present embodiment, the antifouling layer forming step is continuously performed while a decompressed state is maintained without bringing the transparent substrate 11 having the optical function layer 14 with a treated surface, which has been obtained through the second surface treatment step, into contact with atmospheric air. In the antifouling layer forming step, the vapor deposition source 43 is vapor-deposited on the surface of the optical function layer 14 while the transparent substrate 11 having the optical function layer 14 with a treated surface is conveyed at a predetermined conveyance speed by rotating the guide rolls 22.

In the present embodiment, for example, an antifouling material consisting of a fluorine-based organic compound which will become the antifouling layer 15 is heated to a steam pressure temperature by the heating apparatus 53, the obtained vaporized gas is supplied from the vapor deposition source 43 under a decompression environment, the heated antifouling material is adhered to the optical function layer 14 with a treated surface; and thereby, the antifouling layer 15 is formed by vacuum vapor deposition.

For example, the pressure when performing vacuum vapor deposition of the antifouling layer 15 is preferably 0.05 Pa or lower, is more preferably 0.01 Pa or lower, and is particularly preferably 0.001 Pa or lower. If the pressure when performing vacuum vapor deposition is in a decompressed state of 0.05 Pa or lower, the mean free path of film formation molecules is lengthened and the vapor deposition energy increases; and thereby, the dense antifouling layer 15 having more satisfactory quality is obtained.

According to the foregoing method, it is possible to obtain the optical laminate 10 in which the antifouling layer 15 is formed by vacuum vapor deposition on the adhesion layer 13 and the optical function layer 14 formed by sputtering.

Thereafter, the transparent substrate 11 (optical laminate 10) having each of the layers formed thereon up to the antifouling layer 15 is sent out to the roll winding apparatus 5 by the rotation of the guide rolls 22.

Further, inside the chamber 35 of the roll winding apparatus 5, the optical laminate 10 is wound around the winding roll 24 by the rotation of the winding roll 24 and the guide rolls 22.

In the present embodiment, it is preferable to consecutively perform the optical function layer forming step and the antifouling layer forming step in a decompressed state. Particularly, as in the production method of the present embodiment using the production apparatus 20 illustrated in FIG. 4, when the optical laminate 10 is continuously produced as a wound roll by a roll-to-roll method, it is more preferable to consecutively perform the optical function layer forming step and the antifouling layer forming step in an in-line manner while a decompressed state is maintained. The term "in-line" denotes that the antifouling layer forming step is performed without bringing the optical function layer 14 formed in the optical function layer forming step into contact with atmospheric air. Generation of a natural oxide film on the optical function layer 14 formed in the optical function layer forming step before formation of the antifouling layer 15 is curbed by consecutively performing the optical function layer forming step and the antifouling layer forming step in a decompressed state. In addition, it is possible to prevent contaminants such as foreign matters from adhering onto the optical function layer 14 during winding of the roll and inhibiting the adhesive properties between the optical function layer 14 and the antifouling layer 15. Therefore, compared to a case in which after the optical function layer forming step, the transparent substrate 11 having each of the layers formed thereon up to the optical function layer 14 is taken out from the chamber in a decompressed state, and then the transparent substrate 11 is installed inside the chamber again and the antifouling layer forming step is performed in a decompressed state, the adhesive properties between the optical function layer 14 and the antifouling layer 15 become satisfactory, and an optical laminate having more excellent transparency can be obtained.

In addition, since the antifouling layer 15 provided in the optical laminate 10 of the present embodiment is a vapor-deposited film, for example, high wear resistance and liquid resistance can be obtained compared to an antifouling film formed by a coating method. It is assumed that this is due to the following reason. That is, voids caused by a solvent included in a paint are present in an antifouling film formed by a coating method. In contrast, voids caused by a solvent are not present in a vapor-deposited film. For this reason, it is assumed that a vapor-deposited film has a high density and can obtain high wear resistance or alkali resistance compared to an antifouling film formed by a coating method.

The method for producing the optical laminate 10 of the present embodiment includes the adhesion layer forming step of forming the adhesion layer 13, the optical function layer forming step of forming the optical function layer 14 by alternately laminating the high refractive index layers 14a and the low refractive index layers 14b, the second surface treatment step of performing treatment of a surface of the optical function layer 14, and the antifouling layer forming step of forming the antifouling layer 15 on the optical function layer 14 which has been subjected to surface treatment. For this reason, the adhesive properties between the optical function layer 14 and the antifouling layer 15 formed on the optical function layer 14 become satisfactory, and more satisfactory frictional properties and alkali resistance are obtained.

Particularly, in the second surface treatment step, when the surface of the optical function layer is treated such that the rate of change in surface roughness expressed by Expression (1) becomes 1% to 25%, the surface of the optical function layer 14 changes to have an appropriate roughness and the surface is activated due to etching. Therefore, reactivity with respect to the antifouling layer 15 formed on the optical function layer 14 is improved, which is preferable. In addition, in the second surface treatment step, the same applies to the case where the surface of the optical function layer is treated such that the rate of change in average length of the elements expressed by Expression (2) becomes 7 to 65%.

In addition, in the method for producing the optical laminate 10 of the present embodiment, the optical laminate 10 can be continuously formed by a roll-to-roll method, and the film thickness can be controlled with high accuracy. Therefore, it is preferable to form the optical function layer 14 by sputtering in the optical function layer forming step.

In the present embodiment, when the first surface treatment step, the optical function layer forming step, the second surface treatment step, and the antifouling layer forming step are consecutively performed while an optical laminate in the middle of production is maintained in a decompressed state, for example, decompression conditions inside the chamber may differ between the sputtering apparatus and the vapor deposition apparatus as long as they are within a range not hindering each of the production steps.

In the present embodiment, in any one or more steps of the adhesion layer forming step, the optical function layer forming step, and the antifouling layer forming step, it is preferable that film formation results be measured over time using a measurement instrument and the results be subjected to feedback on conditions of the production step corresponding to a succeeding step. Accordingly, characteristics of an optical laminate in its entirety are likely to be optimized, and in-plane characteristics of an optical laminate can be made uniform. In addition, feedback on production conditions in the same step can be performed using a measurement instrument. In this case, a layer which has been formed in this step has uniform and stable characteristics.

In the present embodiment, a case in which the second surface treatment step is performed between the optical function layer forming step and the antifouling layer forming step has been described as an example. However, the second surface treatment step need only be performed as necessary, and it may not be performed. In a case in which the second surface treatment step is not performed as well, it is preferable to consecutively perform the optical function layer forming step and the antifouling layer forming step in a decompressed state.

In the present embodiment, a case in which the optical laminate 10 is continuously produced by a roll-to-roll method using the production apparatus 20 (illustrated in FIG. 4) including the pretreatment apparatus 2A, the sputtering apparatus 1, the pretreatment apparatus 2B, the vapor deposition apparatus 3, the roll unwinding apparatus 4, and the roll winding apparatus 5 has been described as an example. However, the production apparatus for producing the optical laminate 10 is not limited to the production apparatus 20 illustrated in FIG. 4.

For example, a production apparatus which does not include the pretreatment apparatus 2A and the pretreatment apparatus 2B and in which the roll unwinding apparatus 4, the sputtering apparatus 1, the vapor deposition apparatus 3, and the roll winding apparatus 5 are connected in this order may be used.

In the production apparatus 20 illustrated in FIG. 4, a pretreatment chamber (not illustrated) for washing the surface of the optical function layer 14 on which the antifouling layer 15 will be formed may be provided between the chamber 33 of the vapor deposition apparatus 3 and the chamber 32 of the pretreatment apparatus 2B.

In the production apparatus 20 illustrated in FIG. 4, a post-treatment chamber (not illustrated) for performing cooling and/or inspection of the transparent substrate 11 having each of the layers formed thereon up to the antifouling layer 15 may be provided between the chamber 33 of the vapor deposition apparatus 3 and the chamber 35 of the roll winding apparatus 5.

In the production apparatus 20 illustrated in FIG. 4, a hard coating layer forming apparatus for forming the hard coating layer 12 on the surface of the transparent substrate 11 may be provided between the roll unwinding apparatus 4 and the sputtering apparatus 1. In this case, not only the optical function layer 14 and the antifouling layer 15 but the hard coating layer 12 can also be continuously produced by a roll-to-roll method, which is preferable.

In the present embodiment, a case in which the optical function layer forming step is performed using the sputtering apparatus and the antifouling layer forming step is performed using the vapor deposition apparatus has been described as an example. However, when the second surface treatment step is not performed, the optical function layer forming step and the antifouling layer forming step may be performed using the same apparatus (inside one chamber).

In the optical laminate 10 of the present embodiment, various kinds of layers may be provided as necessary on a surface facing the surface on which the optical function layer (transparent substrate) and the like are formed. For example, a pressure sensitive adhesive layer used for adhesion to another member may be provided. In addition, another optical film may be provided with this pressure sensitive adhesive layer therebetween. Examples of another optical film include films functioning as a polarization film, a phase difference compensation film, a 1/2-wavelength plate, and a 1/4-wavelength plate.

In addition, a layer having a function of antireflection, selective reflection, antiglare, polarization, phase difference compensation, compensation or expansion of a viewing angle, optical guiding, diffusion, luminance improvement, hue adjustment, electrical conduction, or the like may be directly formed on a surface facing the transparent substrate.

In addition, the shape of the optical laminate may be a smooth shape or may be a shape having a moth eye or a nano-order uneven structure for realizing an antiglare function. In addition, it may be a geometrical shape (micro-order to millimeter-order) such as a lens or a prism. For example, the shape can be formed by combination of photolithography and etching, shape transfer, hot pressing, or the like. In the present embodiment, since film formation is performed by vapor deposition or the like, even when the base material has an uneven shape, for example, the uneven shape can be maintained.

For example, an article of the present embodiment is realized by providing the optical laminate 10 described above on a display surface of an image display unit such as a liquid crystal display panel or an organic EL display panel. Accordingly, for example, high wear resistance and alkali resistance can be imparted to a touch panel display unit of a smartphone or an operation instrument, and thus it is possible to realize an image display device having excellent durability and suitable for practical use.

In addition, an article is not limited to an image display device. For example, any article may be adopted as long as the optical laminate 10 can be applied thereto, such as a window glass, a goggle, a light reception surface of a solar battery, a screen of a smartphone, a display of a personal computer, an information input terminal, a tablet terminal, an augmented reality (AR) device, a virtual reality (VR) device, an electric display board, a glass table surface, a game machine, a driving support device for an aircraft or an electric railcar, a navigation system, an instrument panel, and a surface of an optical sensor which have the optical laminate of the present embodiment provided on a surface thereof.

Hereinabove, the embodiment of the present invention has been described. However, this embodiment has been presented as an example and is not intended to limit the scope of the invention. This embodiment can be performed in various other forms, and various omissions, replacements, and changes can be performed within a range not departing from the features of the invention. These embodiments and modifications thereof are included in the invention described in the claims and the scope equivalent thereto as they are included in the scope and the features of the invention.

For example, in place of the hard coating layer 12, an antiglare layer can be formed, or an arbitrary functional layer such as a soft coating layer having flexibility can be added as necessary. These may be laminated.

EXAMPLES

The effects of the present invention are verified.

The optical laminates made in the following examples and comparative examples are examples functioning as an antireflection film, and the purport of the present invention is not limited thereto.

(Examples 1 to 5, Comparative Example 2, and Comparative Example 4)

First, a photocurable resin composition of which the content of silica particles (filler) having the average particle size of 50 nm was 28 mass% with respect to the entire solid content of the resin composition (binder resin) was prepared. As shown in Table 1, the resin composition was prepared by dissolving silica particles, acrylate, a leveling agent, and a photopolymerization initiator in a solution.

Table 1

| | Product name | Manufacturer | Structure | Compounding ratio |
|---|---|---|---|---|
| Acrylate | CN968 | SARTOMER | Urethane acrylate oligomer | 8% |
| | SR444 | SARTOMER | Pentaerythritol triacrylate | 7% |
| | SR610 | SARTOMER | Polyethylene glycol (600) diacrylate | 11% |
| Silica particles | IPA-ST-L | NISSAN CHEMICAL | Silica sol having particle size of 40 to 50 nm (solid content 30%, IPA solvent) | 37% |
| Initiator | Irgacure 184 | BASF | Initiator | 2% |
| Solution | PGMA | | Propylene glycol monomethyl ether acetate | 30% |
| | Butyl acetate | | | 5% |
| Total | | | | 100% |
| Leveling agent | BYK377 | BYK | Polyether modified polydimethylsiloxane | 0.01 parts by weight per 100 parts by weight (foregoing total) |

SR610: polyethylene glycol diacrylate, and the average molecular weight of polyethylene glycol chain was 600.

CN968: hexafunctional aliphatic urethane acrylate having a polyester skeleton

Irgacure 184: 1-hydroxy-cyclohexyl-phenyl-ketone

<Hard coating layer forming step>

As the transparent substrate 11, a roll-shaped TAC film having a thickness of 80 μm and a length of 3900 m was prepared, the photocurable resin composition shown in Table 1 was coated on the TAC film using a gravure coater, the TAC film was irradiated with light to be cured; and thereby, the hard coating layer 12 having a thickness of 5 μm was formed.

Next, in a roll-to-roll method, the adhesion layer 13, the optical function layer 14, and the antifouling layer 15 were consecutively produced in this order on the transparent substrate 11 having the hard coating layer 12 formed thereon by the method described below, and the optical laminates (antireflection films) of Examples 1 to 5, Comparative Example 2, and Comparative Example 4 were produced.

As a production apparatus, the production apparatus 20 illustrated in FIG. 4 was used. In addition, the line speed was set to 2 m/min. The first surface treatment step, the adhesion layer forming step, the optical function layer forming step, the second surface treatment step, and the antifouling layer forming step were consecutively performed while the optical laminate in the middle of production was maintained in a decompressed state.

<First surface treatment step>

Next, glow discharge treatment was performed on the hard coating layer 12 while a treatment strength of the glow discharge treatment was set to 4000 W·min/m$^2$.

<Adhesion layer forming step and optical function layer forming step>

The adhesion layer 13 having a thickness of 5 nm and consisting of SiO$_x$ was formed on the hard coating layer 12 after glow discharge treatment by sputtering inside the chamber at a pressure of 1.0 Pa or lower, and the optical function layer 14 (laminate) was formed on the adhesion layer, and the optical function layer 14 consisted of a Nb$_2$O$_5$ film (high refractive index layer) having a thickness of 15 nm, a SiO$_2$ film (low refractive index layer) having a thickness of 38 nm, a Nb$_2$O$_5$ film (high refractive index layer) having a thickness of 30 nm, and a SiO$_2$ film (low refractive index layer) having a thickness of 102 nm.

<Second surface treatment step>

Glow discharge treatment was performed on the surface of the optical function layer 14. In glow discharging, first, the pressure inside the chamber was set to $2 \times 10^{-5}$ Pa. Thereafter, argon gas was introduced into the chamber from the inside of a linear ion source at 800 sccm, and the pressure inside the chamber was set to 0.4 Pa. The integrated output of glow discharging was adjusted by the voltage, the current value, and the treatment time of glow discharging.
In Examples 1 to 3, the integrated output of glow discharge treatment was set to 326 W·min/m$^2$.
In Example 4, the integrated output of glow discharge treatment was set to 760 W·min/m$^2$.
In Example 5, the integrated output of glow discharge treatment was set to 1086 W·min/m$^2$.
In Comparative Example 2, the integrated output of glow discharge treatment was set to 3260 W·min/m$^2$.
In Comparative Example 4, the integrated output of glow discharge treatment was set to 109 W·min/m$^2$.
In addition, Table 2 shows the rate of change in surface roughness expressed by the following Expression (1).

$$\text{Rate of change in surface roughness } (\%) = ((Ra2/Ra1) - 1) \times 100 \ (\%) \ \dots \ \text{Expression}$$

$$(1)$$

(in Expression (1), Ra1 indicates the surface roughness (Ra) of the optical function layer before surface treatment, and Ra2 indicates the surface roughness (Ra) of the optical function layer after surface treatment)

<Antifouling layer forming step>

Next, on the optical function layer 14, the antifouling layer 15 consisting of an alkoxysilane compound (KY-1901, manufactured by SHIN-ETSU CHEMICAL CO., LTD.) having a perfluoropolyether group (an organic compound having fluorine) was formed by vapor deposition, while the pressure inside a vapor deposition chamber was 0.01 Pa or lower, the vapor deposition temperature was 230°C, and the line speed was 2.0 m/min. Table 2 shows the optical film thickness of the obtained antifouling layer 15.
Thereafter, the obtained film was wound in a roll shape, and the optical laminates (antireflection films) of Examples 1 to 5, Comparative Example 2, and Comparative Example 4 were obtained.

Table 2

| | | Example 1 | Example 2 | Example 3 | Example 4 | Example 5 |
|---|---|---|---|---|---|---|
| Transparent substrate | Kind | TAC film | TAC film | TAC film | TAC film | TAC film |
| | Film thickness (μm) | 80 | 80 | 80 | 80 | 80 |
| Hard coating | Film thickness (μm) | 5 | 5 | 5 | 5 | 5 |
| | Filler particle size (μm) | 0.05 | 0.05 | 0.05 | 0.05 | 0.05 |
| Discharge treatment | Presence or absence | Present | Present | Present | Present | Present |
| | Integrated output (W·min/m$^2$) | 326 | 326 | 326 | 760 | 1086 |
| Antifouling layer forming method | | Vapor deposition (consecutive) | Vapor deposition (consecutive) | Vapor deposition (consecutive) | Vapor deposition (consecutive) | Vapor deposition (consecutive) |
| Film thickness (nm) | | 5.0 | 4.0 | 3.0 | 5.0 | 5.0 |
| Antifouling layer Ra (nm) | | 7.9 | 6.3 | 7.0 | 7.8 | 7.2 |
| Rate of change in surface roughness Ra before and after surface treatment (%) | | 10 | 10 | 10 | 12 | 14 |
| Initial state | Contact angle (°) | Pure water | 120 | 120 | 120 | 120 | 120 |
| | | Oleic acid | 84 | 82 | 80 | 83 | 83 |
| | | n-hexadecane | 73 | 72 | 71 | 73 | 72 |
| | | Diiodomethane | 93 | 92 | 88 | 92 | 91 |
| | ESCA | Fluorine content | 210517 | 212170 | 193200 | 240275 | 240138 |
| | XRF | Fluorine content | 0.0474 | 0.0400 | 0.0396 | 0.0513 | 0.0507 |

Table 2 (Continued)

| | | Comparative Example 1 | Comparative Example 2 | Comparative Example 3 | Comparative Example 4 |
|---|---|---|---|---|---|
| Transparent substrate | Kind | TAC film | TAC film | TAC film | TAC film |
| | Film thickness (μm) | 80 | 80 | 80 | 80 |
| Hard coating | Film thickness (μm) | 5 | 5 | 5 | 5 |
| | Filler particle size (μm) | 0.05 | 0.05 | 0.05 | 0.05 |
| Discharge treatment | Presence or absence | Absent | Present | Absent | Absent |
| | Integrated output (W·min/m²) | 0 | 3260 | 0 | 109 |
| Antifouling layer forming method | | Vapor deposition (consecutive) | Vapor deposition (consecutive) | Coating | Vapor deposition (consecutive) |
| Film thickness (nm) | | 5.0 | 5.0 | 7.0 | 5.0 |
| Antifouling layer Ra (nm) | | 5.1 | 8.6 | 2.3 | 7.1 |
| Rate of change in surface roughness Ra before and after surface treatment (%) | | - | 30 | - | 0.7 |
| Initial state | Contact angle (°) | Pure water | 120 | 120 | 114 | 120 |
| | | Oleic acid | 80 | 80 | 76 | - |
| | | n-hexadecane | 72 | 73 | 65 | - |
| | | Diiodomethane | 87 | 90 | 88 | - |
| | ESCA | Fluorine content | 220770 | 240258 | 200218 | 230310 |
| | XRF | Fluorine content | 0.057 | 0.0528 | 0.0579 | 0.0498 |

(Comparative Example 1)

The optical laminate (antireflection film) of Comparative Example 1 was produced in a manner similar to that of Example 1 except that the antifouling layer forming step was performed without performing the second surface treatment step after the procedure was carried out up to the optical function layer forming step in a manner similar to that of Example 1, and then the antifouling layer 15 was formed on the optical function layer 14.

(Comparative Example 3)

After the procedure was carried out up to the optical function layer forming step in a manner similar to that of Example 1, the TAC film having the hard coating layer 12, the adhesion layer 13, and the optical function layer 14 formed thereon was wound up, taken out from the production apparatus, and installed in a roll-to-roll coating apparatus (coater). Thereafter, under atmospheric pressure, the TAC film having the hard coating layer 12, the adhesion layer 13, and the optical function layer 14 formed thereon was unwound, and an antifouling agent was coated on the SiO₂ film (low refractive index layer) of the optical function layer 14 using a gravure coater at a line speed of 20 m/min.

An antifouling agent obtained by diluting an alkoxysilane compound (KY-1901, manufactured by SHIN-ETSU CHEMICAL CO., LTD.) having a perfluoropolyether group using a fluorine solution (Fluorinert FC-3283: manufactured by 3M JAPAN LIMITED) to a concentration of 0.1 mass% was used. Coating was performed with the antifouling agent such that the thickness after being dried became the film thickness shown in Table 2.

Regarding each of the obtained optical laminates (antireflection films) of Examples 1 to 5 and Comparative Examples 1 to 4, the surface roughness Ra of the antifouling layer was examined by the method described below. Table 2 shows the results thereof.

(Measurement of surface roughness Ra of antifouling layer)

A measurement sample (50 mm×50 mm) was cut out from a position at the center in a length direction and a position at the center in a roll width direction of each roll having an optical laminate wound therearound. A surface of the sample was observed using an atomic force microscope (AFM) (brand name: SPA 400, NanoNavill; manufactured by HITACHI, LTD.), and the surface roughness Ra in an area of 1 $\mu$m$^2$ was measured. Measurement was performed at three locations on the sample, and the average value thereof was adopted as a measurement value.

The surface roughness Ra of the antifouling layer was affected by the surface roughness Ra of the optical function layer below the antifouling layer. Particularly, in the antifouling layer formed by vapor deposition, voids caused by a solvent included in a paint were not present as in the antifouling layer formed by a coating method, and the antifouling layer was formed to have a high density. Therefore, compared to the antifouling layer formed by a coating method, the antifouling layer was significantly affected by the surface roughness Ra of the optical function layer below the antifouling layer. The surface roughness on the surface of the optical function layer increased by performing glow discharge treatment, and the surface roughness of the antifouling layer increased due to the influence thereof. In addition, when the optical function layer came into contact with atmospheric air, a natural oxide film was formed on the optical function layer, and the surface roughening effect due to glow discharge treatment decreased. In contrast, when the optical function layer and the antifouling layer were formed without coming into contact with atmospheric air, there was no such an influence. In addition, the difference in surface roughness between Example 1 and Comparative Example 1 was caused by the presence or absence of glow discharge treatment.

(Examples 6 to 8 and Comparative Examples 5 to 8)

Examples 6 to 8 and Comparative Examples 5 to 8 differed from Examples 1 to 5 and Comparative Examples 1 to 3 in that the constitution of hard coating was changed. In Examples 6 to 8 and Comparative Examples 5 to 8, the hard coating layer forming step was not performed, and a commercially available film (manufactured by DAI NIPPON PRINTING CO., LTD.) was used. The hard coating layer was a cured object of an acryl-based resin composition having a filler with the average particle size of 2 $\mu$m. The film thickness of the hard coating layer was 3 $\mu$m. The hard coating layer was laminated on the TAC (transparent substrate) having a thickness of 80 $\mu$m. Further, in Examples 6 to 8 and Comparative Example 5 and 6, the first surface treatment step, the adhesion layer forming step, the optical function layer forming step, the second surface treatment step, and the antifouling layer forming step were sequentially performed on the hard coating layer. In Comparative Example 7, the second surface treatment step was not performed. In Comparative Example 8, the second surface treatment step was not performed, and the antifouling layer was formed by a coating method in a manner similar to that of Comparative Example 3.

The integrated output in each of the examples in which glow discharge treatment was performed in the second surface treatment step was as follows.

In Examples 6 and 8, the integrated output of glow discharge treatment was set to 1086 W·min/m$^2$.

In Example 7, the integrated output of glow discharge treatment was set to 1629 W·min/m$^2$.

In Comparative Example 5, the integrated output of glow discharge treatment was set to 3260 W·min/m$^2$.

In Comparative Example 6, the integrated output of glow discharge treatment was set to 109 W·min/m$^2$.

In addition, in these Examples and Comparative Examples, the rate of change in average length of the elements expressed by the following Expression (2) was measured.

$$\text{Rate of change in average length of elements (\%)} = ((RSm2/RSm1) - 1) \times 100 \ (\%) \ \dots$$

Expression (2)

(in Expression (2), RSm1 indicates the average length (RSm) of the elements of the optical function layer before surface treatment, and RSm2 indicates the average length (RSm) of the elements of the optical function layer after surface treatment)

(Measurement of average length RSm of elements of antifouling layer)

A measurement sample (50 mm×50 mm) was cut out from a position at the center in a length direction and a position at the center in a roll width direction of each roll having an optical laminate wound therearound. A surface of the sample was measured using an atomic force microscope (AFM) (brand name: SPA 400, NanoNavill; manufactured by HITACHI, LTD.), three straight lines in a top view not affected by a filler for realizing an antiglare function included in the hard coating layer were selected, and the average length RSm of the elements in an area of 0.5 $\mu$m$^2$ was calculated as the average value from actual unevenness in the three straight lines. Table 3 summarizes the results of these examples.

Table 3

| | | Example 6 | Example 7 | Example 8 | Comparative Example 5 | Comparative Example 6 | Comparative Example 7 | Comparative Example 8 |
|---|---|---|---|---|---|---|---|---|
| Transparent substrate | Kind | TAC film | TAC film | TAC film | TAC film | TAC film | TAC film | TAC film |
| | Film thickness (μm) | 80 | 80 | 80 | 80 | 80 | 80 | 80 |
| Hard coating | Film thickness (μm) | 3 | 3 | 3 | 3 | 3 | 3 | 3 |
| | Filler particle size (μm) | 2.0 | 2.0 | 2.0 | 2.0 | 2.0 | 2.0 | 2.0 |
| Discharge treatment | Presence or absence | Present | Present | Present | Present | Present | Absent | Absent |
| | Integrated output (W·min/m²) | 1086 | 1629 | 1086 | 3260 | 109 | 0 | 0 |
| Antifouling layer forming method | | Vapor deposition (consecutive) | Vapor deposition (consecutive) | Vapor deposition (consecutive) | Vapor deposition (consecutive) | Vapor deposition (consecutive) | Vapor deposition (consecutive) | Coating |
| Film thickness (nm) | | 5.0 | 5.0 | 4.0 | 5.0 | 5.0 | 4.0 | 3.0 |
| Antifouling layer RSm (nm) | | 59.2 | 76.8 | 59.2 | 92.8 | 55 | 53.1 | 53.1 |
| Rate of change in surface roughness RSm before and after surface treatment (%) | | 11.5% | 44.6% | 11.5% | 74.8% | 3.6% | - | - |
| Initial state | Contact angle (°) — Pure water | 116.7 | 117.7 | 117.0 | 117.0 | 117.1 | 116.3 | 115.4 |
| | Oleic acid | 77 | 78 | 77 | 79 | 78 | 77 | 79 |
| | n-hexadecane | 68 | 71 | 71 | 71 | 71 | 71 | 72 |
| | Diiodomethane | 91 | 92 | 90 | 90 | 90 | 89 | 92 |
| | XRF — Fluorine content | 0.0465 | 0.0480 | 0.0410 | 0.0500 | 0.0500 | 0.0419 | 0.0531 |

(Examples 9 to 12 and Comparative Examples 9 to 12)

Examples 9 to 12 and Comparative Examples 9 to 12 differed from Examples 1 to 5 and Comparative Examples 1 to 3 in that the constitution of hard coating was changed. In Examples 9 to 12 and Comparative Examples 9 to 12, the hard coating layer forming step was not performed, and a commercially available film (manufactured by DAI NIPPON PRINTING CO., LTD.) was used. The hard coating layer was a cured object of an acryl-based resin composition having a filler with the average particle size of 2 $\mu$m. The film thickness of the hard coating layer was 5 $\mu$m. The hard coating layer was laminated on the TAC (transparent substrate) having a thickness of 60 $\mu$m. Further, in Examples 9 to 12 and Comparative Example 9 and 10, the first surface treatment step, the adhesion layer forming step, the optical function layer forming step, the second surface treatment step, and the antifouling layer forming step were sequentially performed on the hard coating layer. In Comparative Example 11, the second surface treatment step was not performed. In Comparative Example 12, the second surface treatment step was not performed, and the antifouling layer was performed by a coating method in a manner similar to that of Comparative Example 3.

The integrated output in each of the examples in which glow discharge treatment was performed in the second surface treatment step was as follows.

In Examples 9 and 12, the integrated output of glow discharge treatment was set to 1086 W·min/m$^2$.

In Example 10, the integrated output of glow discharge treatment was set to 1629 W·min/m$^2$.

In Example 11, the integrated output of glow discharge treatment was set to 543 W·min/m$^2$.

In Comparative Example 9, the integrated output of glow discharge treatment was set to 3260 W·min/m$^2$.

In Comparative Example 10, the integrated output of glow discharge treatment was set to 109 W·min/m$^2$.

Table 4 summarizes the results of these examples.

Table 4

| | | | Example 9 | Example 10 | Example 11 | Example 12 | Comparative Example 9 | Comparative Example 10 | Comparative Example 11 | Comparative Example 12 |
|---|---|---|---|---|---|---|---|---|---|---|
| Transparent substrate | | Kind | TAC film | TAC film | TAC film | TAC film | TAC film | TAC film | TAC film | TAC film |
| | | Film thickness ($\mu$m) | 60 | 60 | 60 | 60 | 60 | 60 | 60 | 60 |
| Hard coating | | Film thickness ($\mu$m) | 5 | 5 | 5 | 5 | 5 | 5 | 5 | 5 |
| | | Filler particle size ($\mu$m) | 2.0 | 2.0 | 2.0 | 2.0 | 2.0 | 2.0 | 2.0 | 2.0 |
| Discharge treatment | | Presence or absence | Present | Present | Present | Present | Present | Present | Absent | Absent |
| | | Integrated output (W·min/m$^2$) | 1086 | 1629 | 543 | 1086 | 3260 | 109 | 0 | 0 |
| Antifouling layer forming method | | | Vapor deposition (consecutive) | Vapor deposition (consecutive) | Vapor deposition (consecutive) | Vapor deposition (consecutive) | Vapor deposition (consecutive) | Vapor deposition (consecutive) | Vapor deposition (consecutive) | Coating |
| Film thickness (nm) | | | 5.0 | 5.0 | 5.0 | 4.0 | 5.0 | 5.0 | 4.0 | 3.0 |
| Antifouling layer RSm (nm) | | | 60.9 | 86.2 | 60.9 | 62.1 | 108 | 54 | 53.4 | 53.4 |
| Rate of change in surface roughness RSm before and after surface treatment (%) | | | 14.0% | 61.4% | 14.0% | 16.3% | 102.2% | 1.1% | - | - |
| Initial state | Contact angle (°) | Pure water | 117.0 | 116.3 | 116.9 | 117.3 | 117 | 117.1 | 116.3 | 114.4 |
| | | Oleic acid | 80 | 80 | 79 | 78 | 79 | 78 | 77 | 77 |
| | | n-hexadecane | 72 | 71 | 72 | 70 | 71 | 71 | 71 | 69 |
| | | Diiodomethane | 89 | 91 | 91 | 90 | 90 | 90 | 90 | 90 |
| | XRF | Fluorine content | 0.0506 | 0.0478 | 0.0522 | 0.0456 | 0.0500 | 0.05 | 0.0438 | 0.0593 |

EP 4 183 573 A1

In addition, characteristics of each of the optical laminates (antireflection films) of the foregoing Examples and Comparative Examples were examined. The following tables show the results thereof. Test pieces used for characteristic measurement were cut out from parts near substantially the center in the length direction of the roll having an optical laminate wound therearound.

Table 5

| | | | Example 1 | Example 2 | Example 3 | Example 4 | Example 5 |
|---|---|---|---|---|---|---|---|
| Waste cloth scratch test | Pure water contact angle (°) | Reciprocating of zero times | 120 | 120 | 120 | 120 | 120 |
| | | Reciprocating of 500 times | 120 | 120 | 117 | 120 | 119 |
| | | Reciprocating of 1000 times | 120 | 117 | 114 | 120 | 118 |
| | | Reciprocating of 2000 times | 120 | 114 | 111 | 120 | 113 |
| | | Reciprocating of 4000 times | 119 | 111 | 108 | 120 | 109 |
| | | Contact angle difference | 1 | 9 | 12 | 0 | 11 |
| | ESCA fluorine content | Before test | 210517 | 212170 | 193200 | 240275 | 240138 |
| | | After test | 209800 | - | - | 187210 | 174074 |
| | | Residual ratio | 99.7% | 96.8% | 95.2% | 77.9% | 72.5% |
| | Hue change | ΔE value (SCI) | 0.8 | 2.3 | 3.6 | 2.9 | 3.5 |
| Alkali resistance test | XRF fluorine content | Before test | 0.0474 | 0.0400 | 0.0396 | 0.0513 | 0.0507 |
| | | After test | 0.0433 | 0.0387 | 0.0377 | 0.043 | 0.0564 |
| | | Residual ratio | 91.4% | 96.8% | 95.2% | 83.8% | 91.5% |

Table 5 (Continued)

| | | | Comparative Example 1 | Comparative Example 2 | Comparative Example 3 | Comparative Example 4 |
|---|---|---|---|---|---|---|
| Waste cloth scratch test | Pure water contact angle (°) | Reciprocating of zero times | 120 | 120 | 114 | 120 |
| | | Reciprocating of 500 times | 110 | 112 | 114 | 112 |
| | | Reciprocating of 1000 times | 108 | 111 | 112 | 110 |
| | | Reciprocating of 2000 times | 103 | 108 | 101 | 102 |
| | | Reciprocating of 4000 times | 103 | 105 | 94 | 102 |
| | | Contact angle difference | 17 | 15 | 20 | 18 |
| | ESCA fluorine content | Before test | 221656 | 240258 | 200218 | 230310 |
| | | After test | 154836 | 157374 | 160583 | 157709.5 |
| | | Residual ratio | 69.9% | 65.5% | 80.0% | 68% |
| Alkali resistance test | Hue change | ΔE value (SCI) | 13.3 | 6.3 | 36.7 | 8 |
| | XRF fluorine content | Before test | 0.0570 | 0.0528 | 0.0579 | 0.0498 |
| | | After test | 0.0108 | 0.0025 | 0.0100 | 0.011 |
| | | Residual ratio | 18.9% | 4.7% | 17.3% | 22% |

Table 6

| | | | Example 6 | Example 7 | Example 8 | Comparative Example 5 | Comparative Example 6 | Comparative Example 7 | Comparative Example 8 |
|---|---|---|---|---|---|---|---|---|---|
| Waste cloth scratch test | Pure water contact angle (°) | Reciprocating of zero times | 118 | 117 | 118 | 117 | 117.1 | 118 | 117 |
| | | Reciprocating of 500 times | 118 | 118 | 116 | 115 | 115 | 115 | 115 |
| | | Reciprocating of 1000 times | 113 | 114 | 114 | 112 | 114 | 114 | 115 |
| | | Reciprocating of 2000 times | 113 | 114 | 115 | 110 | 113 | 113 | 114 |
| | | Reciprocating of 4000 times | 110 | 114 | 114 | 107 | 111 | 110 | 112 |
| | | Contact angle difference | 7 | 3 | 4 | 10 | 6.1 | 8 | 5 |
| | ESCA fluorine content | Before test | 232500 | 240000 | 205000 | 235000 | 237500 | 209500 | 265500 |
| | | After test | 190566 | 198726 | 198726 | 184446 | 192606 | 190566 | 194646 |
| | | Residual ratio | 82.0% | 82.8% | 96.9% | 78.5% | 81.1% | 91.0% | 73.3% |
| Alkali resistance test | Hue change | $\Delta E$ value (SCI) | 3.3 | 1.2 | 3.0 | 25 | 23 | 20.8 | 25.1 |
| | XRF fluorine content | Before test | 0.0465 | 0.0480 | 0.0410 | 0.047 | 0.0475 | 0.419 | 0.0531 |
| | | After test | 0.0433 | 0.0471 | 0.0384 | 0.0195 | 0.0219 | 0.0215 | 0.0219 |
| | | Residual ratio | 93.0% | 98.0% | 93.8% | 41.4% | 46.2% | 51.4% | 41.2% |

Table 7

| | | Example 9 | Example 10 | Example 11 | Example 12 | Comparative Example 9 | Comparative Example 10 | Comparative Example 11 | Comparative Example 12 |
|---|---|---|---|---|---|---|---|---|---|
| Waste cloth scratch test | Pure water contact angle (°) | | | | | | | | |
| | Reciprocating of zero times | 115 | 115 | 115 | 117 | 117 | 117 | 117 | 118 |
| | Reciprocating of 500 times | 121 | 121 | 119 | 119 | 116 | 115 | 119 | 117 |
| | Reciprocating of 1000 times | 121 | 121 | 119 | 118 | 114 | 112 | 117 | 116 |
| | Reciprocating of 2000 times | 119 | 121 | 116 | 114 | 111 | 109 | 114 | 115 |
| | Reciprocating of 4000 times | 115 | 121 | 117 | 111 | 110 | 107 | 114 | 115 |
| | Contact angle difference | 0 | -6 | -2 | 6 | 7 | 10 | 3 | 3 |
| ESCA fluorine content | Before test | 253000 | 239000 | 261000 | 228000 | 250500 | 246000 | 219000 | 296500 |
| | After test | 200766 | 213006 | 204846 | 192606 | 190566 | 184446 | 198726 | 200766 |
| | Residual ratio | 79.4% | 89.1% | 78.5% | 84.5% | 76.1% | 75.0% | 90.7% | 67.7% |
| Hue change | ΔE value (SCI) | 3.1 | 2.0 | 2.3 | 2.7 | 32 | 30 | 34.8 | 23.4 |
| Alkali resistance test | XRF fluorine content | | | | | | | | |
| | Before test | 0.0506 | 0.0478 | 0.0522 | 0.0456 | 0.0501 | 0.0492 | 0.0438 | 0.0593 |
| | After test | 0.0473 | 0.0460 | 0.0498 | 0.0431 | 0.0124 | 0.0145 | 0.0079 | 0.0268 |
| | Residual ratio | 93.5% | 96.1% | 95.4% | 94.5% | 24.7% | 29.5% | 18.1% | 45.2% |

Table 8

| | | | Example 1 | Example 2 | Example 3 | Example 4 | Example 5 |
|---|---|---|---|---|---|---|---|
| Steel wool scratch test | Pure water contact angle (°) | Reciprocating of zero times | 120 | 118 | 121 | 118 | 118 |
| | | Reciprocating of 250 times | 114 | - | - | 112 | 112 |
| | | Reciprocating of 500 times | 112 | 109 | 109 | 110 | 110 |
| | | Contact angle difference | 8 | 9 | 12 | 8 | 8 |
| | Hue change | $\Delta E$ value (SCI) | 2.4 | 1.76 | 1.42 | 1.0 | 0.9 |
| | | $\Delta E$ value (SCE) | 0.5 | 0.2 | 0.18 | 0.41 | 0.3 |
| Ultrasonic washing | XRF | Before test | 0.0474 | 0.0400 | 0.0396 | 0.0513 | 0.0507 |
| | | After test | 0.0406 | 0.0418 | 0.0424 | 0.455 | 0.0403 |
| | | XRF residual ratio | 85.7% | 104.5% | 107.1% | 88.7% | 79.5% |

Table 8 (Continued)

| | | | Comparative Example 1 | Comparative Example 2 | Comparative Example 3 | Comparative Example 4 |
|---|---|---|---|---|---|---|
| Steel wool scratch test | Pure water contact angle (°) | Reciprocating of zero times | 117 | 116 | 113 | 118 |
| | | Reciprocating of 250 times | 105 | 111 | 103 | 108 |
| | | Reciprocating of 500 times | 99 | 109 | 98 | 104 |
| | | Contact angle difference | 18 | 7 | 14 | 14 |
| | Hue change | ΔE value (SCI) | 3.92 | 2.0 | 3.5 | 3.2 |
| | | ΔE value (SCE) | 0.56 | 0.24 | 0.12 | 0.5 |
| Ultrasonic washing | XRF | Before test | 0.0570 | 0.528 | 0.579 | 0.0498 |
| | | After test | 0.0347 | 0.402 | 0.0363 | 0.033 |
| | | XRF residual ratio | 60.9% | 76.1% | 62.7% | 66% |

Table 9

| | | Example 6 | Example 7 | Example 8 | Comparative Example 5 | Comparative Example 6 | Comparative Example 7 | Comparative Example 8 |
|---|---|---|---|---|---|---|---|---|
| Steel wool scratch test | Pure water contact angle (°) Reciprocating of zero times | 117.2 | 116.5 | 116.5 | 117 | 117.1 | 115.5 | 115.4 |
| | Reciprocating of 100 times | 96.1 | 96.3 | 94.2 | 91.3 | 93 | 92.1 | 100 |
| | Contact angle difference | 21.1 | 20.2 | 22.3 | 25.7 | 24.1 | 23.4 | 15.4 |
| Hue change | ΔE value (SCI) | 1.8 | 1.66 | 1.12 | 1.7 | 1.4 | 1.81 | 1.78 |
| Ultrasonic washing | XRF Before test | 0.0465 | 0.0480 | 0.0410 | 0.047 | 0.0475 | 0.0419 | 0.0531 |
| | After test | 0.0394 | 0.0371 | 0.0361 | 0.039151 | 0.031825 | 0.0344 | 0.0337 |
| | XRF residual ratio | 84.7% | 77.3% | 88.0% | 83.3% | 67.0% | 82.1% | 63.5% |

Table 10

| | | | Example 9 | Example 10 | Example 11 | Example 12 | Comparative Example 9 | Comparative Example 10 | Comparative Example 11 | Comparative Example 12 |
|---|---|---|---|---|---|---|---|---|---|---|
| Steel wool scratch test | Pure water contact angle (°) | Reciprocating of zero times | 117.0 | 116.3 | 116.9 | 117.3 | 117 | 117.1 | 116.3 | 114.4 |
| | | Reciprocating of 100 times | 107.0 | 108.2 | 102.6 | 97.8 | 97 | 99 | 98.3 | 97.0 |
| | | Contact angle difference | 10.0 | 8.1 | 14.3 | 19.5 | 20 | 18.1 | 18.0 | 17.4 |
| | Hue change | ΔE value (SCI) | 0.51 | 1.52 | 1.11 | 1.32 | 1.7 | 1.2 | 0.97 | 1.16 |
| Ultrasonic washing | XRF | Before test | 0.506 | 0.0478 | 0.0522 | 0.0456 | 0.0501 | 0.0492 | 0.0438 | 0.0593 |
| | | After test | 0.432 | 0.0415 | 0.0405 | 0.0389 | 0.041984 | 0.030996 | 0.0376 | 0.0339 |
| | | XRF residual ratio | 85.4% | 86.8% | 77.6% | 85.3% | 83.8% | 63.0% | 85.8% | 57.2% |

(1) Contact angle (antifouling properties)

(1-1) Contact angle measurement test with respect to pure water

Measurement was performed by an ellipse fitting method using a fully automatic contact angle meter DM-700 (manufactured by KYOWA INTERFACE SCIENCE CO., LTD.) under the following conditions. Distilled water was charged into a glass syringe, a stainless steel needle was attached to the tip thereof, and pure water was dripped onto the optical laminate (test piece).

Amount of dripped pure water: 2.0 μL
Measurement temperature: 25°C

Pure water was dripped, the contact angle after the lapse of four seconds was measured at six arbitrary locations on a surface of the test piece, and the average value thereof was adopted as the pure water contact angle.

(1-2) Contact angle measurement test with respect to oleic acid, n-hexadecane, and diiodomethane (reagent)

Measurement was performed by an ellipse fitting method using a fully automatic contact angle meter DM-700 (manufactured by KYOWA INTERFACE SCIENCE CO., LTD.) under the following conditions. Each of the foregoing reagents was charged into a glass syringe, a stainless steel needle was attached to the tip thereof, and each reagent was individually dripped onto the optical laminate (test piece).

Amount of each dripped reagent: 2.0 μL
Measurement temperature: 25°C

Each reagent was dripped, the contact angle after the lapse of four seconds was measured at ten arbitrary locations on a surface of the test piece, and the average value thereof was adopted as the contact angle of each of oleic acid, n-hexadecane, and diiodomethane.

(2) Fluorine content measurement test

The fluorine content (cps: counts per unit time) of the optical laminate (test piece) was measured (fluorine content (fluorine content in an initial state) before washing).
For measurement of the fluorine content, an electron spectroscopy for chemical analysis (ESCA) (PHI 5000 VersaProbeII, manufactured by ULVAC-PHI, INCORPORATED) and an X-ray fluorescence analysis (XRF) (EDX-8000, manufactured by SHIMADZU CORPORATION) were used. The fluorine value (cps) obtained by the electron spectroscopy for chemical analysis and the X-ray fluorescence analysis method was the average value calculated from the results obtained through measurement while having n=3 in the initial state and n=15 after an alkali resistance test.

(3) Alkali resistance test

Optical characteristics of the optical laminate (test piece) were measured (untreated sample).
Next, a sodium hydroxide aqueous solution (reagent) having a concentration of 0.1 mol/L was adjusted.
Further, a cylindrical member having an inner diameter of 38 mm was adhered to the optical laminate (test piece), the reagent was dripped thereinto, and an opening on the upper surface was covered with a glass plate. Further, after being left alone for four hours while maintaining a liquid temperature of 55°C, each test piece was washed with distilled water; and thereby, a treated sample was obtained.

(3-1) Optical characteristic measurement (hue change)

The rear surfaces of the untreated sample and the treated sample described above were attached to a black acrylic plate using a transparent tape to eliminate reflection on the rear surfaces. Further, optical characteristics were measured.
An integrating sphere spectrocolorimeter (SP-64: manufactured by X-Rite INC.) was used for optical measurement. Setting was performed with D65 light source at 10°, and the ΔE value which was the amount of change in the value of L*a*b* (conforming to CIE 1976) indicated by the foregoing Expression (2) by specular component included (SCI, a method for measuring reflected color taking specular reflection light into consideration) of the untreated sample and the treated sample was calculated.

(3-2) Fluorine residual amount measurement test using alkaline solution

Similar to the test of (2) described above, the fluorine content (cps) of the treated sample with an alkaline solution was measured using ESCA or XRF, and the residual ratio (%) of fluorine of the treated sample was calculated.

(4) Scratch test using steel wool

Using a friction tester (I-type) in accordance with JIS L0849, a test piece was obtained by causing a friction body to perform horizontal reciprocating motion along a surface of the optical laminate (test piece).

Steel wool (manufactured by BONSTAR CO., LTD., No. #0000) was used as a friction body. Regarding setting for the test, the load was set to 1000 $g/cm^2$, the stroke was set to 75 mm, and the speed was set to 7 mm/s. Tables show the number of times of horizontal reciprocating of the friction body.

(4-1) Contact angle

Similar to the test of (1-1) described above, the contact angle of the test piece after friction was measured, and the contact angle difference between the test pieces before friction and after friction of 500 times of horizontal reciprocating motion (100 times of horizontal reciprocating motion in Examples 6 to 12 and Comparative Examples 5 to 12) was obtained. The test was performed within 30 minutes after friction.

(4-2) Optical characteristic measurement (hue change)

Similar to the test of (3-1) described above, the ΔE values which were the amounts of change in ΔL*a*b* value obtained by SCI of the test piece before friction and after friction of 500 times of horizontal reciprocating motion (100 times of horizontal reciprocating motion in Examples 6 to 12 and Comparative Examples 5 to 12) were calculated.

In addition, similar to the test of (3-1) described above, the ΔE values which were the amounts of change in L*a*b* value indicated by the foregoing Expression (3) by specular component excluded (SCE, a method for measuring reflected color not taking specular reflection light into consideration) of the test piece before friction and after friction of 500 times of horizontal reciprocating motion (100 times of horizontal reciprocating motion in Examples 6 to 12 and Comparative Examples 5 to 12) were calculated.

(5) Scratch test using waste cloth (nonwoven fabric wiper)

A scratch test was performed in a manner similar to the scratch test using steel wool except that a waste cloth (nonwoven fabric wiper) (BEMCOT LINT-FREE CT-8, manufactured by ASAHI KASEI CORPORATION) was used as a friction body. Regarding setting for the test, the load was set to 250 $g/cm^2$, the stroke was set to 25 mm, and the speed was set to 50 mm/s. Tables show the number of times of horizontal reciprocating motion of the friction body.

(5-1) Contact angle

Similar to the test of (1-1) described above, the contact angle of the test piece after friction was measured, and the contact angle difference between the test pieces before friction and after friction of 4000 times of horizontal reciprocating motion was obtained. The test was performed within 30 minutes after friction.

(5-2) Fluorine residual amount measurement test

Similar to the test of (2) described above, the fluorine content (cps) of the treated sample was measured after horizontal reciprocating motion was performed 4000 times using a waste cloth by ESCA, and the residual ratio (%) of fluorine of the treated sample was calculated.

(6) Ultrasonic washing test

A fluorine-based solution (Fluorinert FC-3283: manufactured by 3M JAPAN LIMITED) was put into a container, the optical laminate (test piece) was immersed, and ultrasonic waves of 40 KHz and 240 W were applied thereto for 10 minutes using an ultrasonic washer (USK-5R, manufactured by AS ONE CORPORATION). Thereafter, the test piece was washed off using the fluorine-based solution. Further, the fluorine content (cps) of the sample after ultrasonic washing was measured using XRF, and the residual ratio (%) of fluorine of the washed sample was calculated.

As shown in Tables 2 to 4, in the optical laminates of Examples 1 to 5 in which the surface treatment step of performing treatment of the surface of the optical function layer 14 and the antifouling layer forming step of forming the antifouling layer 15 on the optical function layer 14 which has been subjected to surface treatment were performed, it could be confirmed that the residual ratio of fluorine in an alkali resistance test was high, the hue change ΔE was also 5 or smaller, which was small, and the alkali resistance was satisfactory as compared to Comparative Example 1 in which the surface treatment step was not performed.

In addition, in the optical laminates of Examples 1 to 5, the contact angle difference in a scratch test using a waste cloth (nonwoven fabric wiper) was 14 or smaller, which was small, and the residual ratio of fluorine was high as compared to Comparative Examples 1 and 2.

In the optical laminates of Examples 1 to 5, the hue change in an alkali resistance test was small, and the residual ratio of fluorine was high as compared to Comparative Examples 1 and 2.

In the optical laminates of Examples 1 to 5, the contact angle difference in a scratch test using a waste cloth (nonwoven fabric wiper) was 14 or smaller, which was small, the hue change in an alkali resistance test was small, and the residual ratio of fluorine was high as compared to Comparative Example 3.

Explanation of Reference Signs

> 10, 101, 102 Optical laminate
> 11 Transparent substrate
> 12 Hard coating layer
> 13 Adhesion layer
> 14 Optical function layer
> 14a High refractive index layer
> 14b Low refractive index layer
> 15 Antifouling layer
> 20 Production apparatus
> 1 Sputtering apparatus
> 2A, 2B Pretreatment apparatus
> 3 Vapor deposition apparatus
> 4 Roll unwinding apparatus
> 5 Roll winding apparatus
> 20 Production apparatus
> 21 Vacuum pump
> 22 Guide roll
> 23 Unwinding roll
> 24 Winding roll
> 25 Film formation roll
> 26 Can roll
> 31, 32, 33, 34, 35 Chamber
> 41 Film formation portion
> 42 Plasma discharge apparatus
> 43 Vapor deposition source
> 53 Heating apparatus

**Claims**

1.　A method for producing an optical laminate including a plastic film, an adhesion layer, an optical function layer, and an antifouling layer which are laminated in this order, the method comprising:

> an adhesion layer forming step of forming an adhesion layer;
> an optical function layer forming step of forming an optical function layer;
> a surface treatment step of performing treatment of a surface of the optical function layer such that a rate of change in surface roughness expressed by the following Expression (1) becomes 1% to 25% or a rate of change in average length of elements expressed by the following Expression (2) becomes 7 to 65%; and
> an antifouling layer forming step of forming an antifouling layer on the optical function layer which has been subjected to surface treatment,

$$\text{Rate of change in surface roughness (\%)} = ((Ra2/Ra1)-1) \times 100 \ (\%) \ \ldots \ \text{Expression (1)}$$

(in Expression (1), Ra1 indicates a surface roughness (Ra) of the optical function layer before surface treatment, and Ra2 indicates the surface roughness (Ra) of the optical function layer after surface treatment)

$$\text{Rate of change in average length of elements (\%)} = ((RSm2/RSm1)-1) \times 100 \ (\%) \ \ldots \ \text{Expression (2)}$$

(in Expression (2), RSm1 indicates an average length (RSm) of elements of the optical function layer before surface treatment, and RSm2 indicates the average length (RSm) of elements of the optical function layer after surface treatment).

2. A method for producing an optical laminate including a plastic film, an adhesion layer, an optical function layer, and an antifouling layer which are laminated in this order, the method comprising:

an adhesion layer forming step of forming an adhesion layer;
an optical function layer forming step of forming an optical function layer;
a surface treatment step of performing glow discharge treatment of a surface of the optical function layer; and
an antifouling layer forming step of forming an antifouling layer on the optical function layer which has been subjected to surface treatment,
wherein an integrated output of the glow discharge treatment is 130 W·min/m$^2$ to 2000 W·min/m$^2$.

3. The method for producing an optical laminate according to claim 1 or 2,
wherein in the adhesion layer forming step and the optical function layer forming step, the adhesion layer and the optical function layer are formed by sputtering.

4. The method for producing an optical laminate according to any one of claims 1 to 3,
wherein in the antifouling layer forming step, the antifouling layer is formed by vacuum vapor deposition.

5. The method for producing an optical laminate according to any one of claims 1 to 4,
wherein the adhesion layer forming step, the optical function layer forming step, the surface treatment step, and the antifouling layer forming step are consecutively performed in a decompressed state.

6. The method for producing an optical laminate according to any one of claims 1 to 5 further comprising:
a hard coating layer forming step of forming a hard coating layer before the adhesion layer forming step.

7. The method for producing an optical laminate according to any one of claims 1 to 6,
wherein the optical function layer includes any one selected from an antireflection layer and a selective reflection layer.

8. The method for producing an optical laminate according to any one of claims 1 to 7,
wherein the optical function layer includes a low refractive index layer.

9. The method for producing an optical laminate according to any one of claims 1 to 7,
wherein the optical function layer forming step is a step of forming a laminate by alternately laminating a low refractive index layer and a high refractive index layer.

10. The method for producing an optical laminate according to claim 8 or 9,
wherein in the surface treatment step, a surface of the low refractive index layer is treated.

11. The method for producing an optical laminate according to any one of claims 8 to 10,
wherein the low refractive index layer includes a metal oxide.

12. The method for producing an optical laminate according to any one of claims 1 to 11, wherein the adhesion layer includes a metal or a metal oxide.

FIG. 1

<u>101</u>

15

14

13

11

FIG. 2

<u>102</u>

15

14

13

12

11

FIG. 3

FIG. 4

### INTERNATIONAL SEARCH REPORT

| International application No. |
| --- |
| PCT/JP2021/026794 |

**A. CLASSIFICATION OF SUBJECT MATTER**
Int.Cl. B32B9/00(2006.01)i, G02B1/11(2015.01)i, G02B1/115(2015.01)i,
G02B1/14(2015.01)i, G02B1/18(2015.01)i, C23C14/06(2006.01)i,
B32B7/023(2019.01)i
FI: G02B1/18, B32B7/023, B32B9/00A, C23C14/06Q, G02B1/14, G02B1/115, G02B1/11
According to International Patent Classification (IPC) or to both national classification and IPC

**B. FIELDS SEARCHED**

Minimum documentation searched (classification system followed by classification symbols)
Int.Cl. B32B9/00, G02B1/11, G02B1/115, G02B1/14, G02B1/18, C23C14/06,
B32B7/023

Documentation searched other than minimum documentation to the extent that such documents are included in the fields searched
Published examined utility model applications of Japan    1922-1996
Published unexamined utility model applications of Japan    1971-2021
Registered utility model specifications of Japan    1996-2021
Published registered utility model applications of Japan    1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | WO 2019/078313 A1 (AGC INC.) 25 April 2019 (2019-04-25), claims, paragraphs [0007], [0014], [0030], [0036], [0042]-[0044], [0057]-[0072], examples | 1, 3-12 |
| Y | WO 2019/064969 A1 (NITTO DENKO CORPORATION) 04 April 2019 (2019-04-04), claims, paragraphs [0047]-[0060], examples | 1, 3-12 |
| X | JP 2008-062460 A (KONICA MINOLTA HOLDINGS, INC.) 21 March 2008 (2008-03-21), claims, paragraphs [0013], [0165], [0167], [0176]-[0178], [0210]-[0283], examples | 2, 5-12 |
| A | CN 105835465 A (NANCHANG O-FILM TECH CO., LTD.) 10 August 2016 (2016-08-10), claims, examples | 1-12 |

☒ Further documents are listed in the continuation of Box C.      ☒ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 17 August 2021 | 31 August 2021 |

| Name and mailing address of the ISA/ | Authorized officer |
| --- | --- |
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**EP 4 183 573 A1**

<table>
<tr><td colspan="2" rowspan="2"><strong>INTERNATIONAL SEARCH REPORT</strong></td><td>International application No.</td></tr>
<tr><td>PCT/JP2021/026794</td></tr>
<tr><td colspan="3">C (Continuation). DOCUMENTS CONSIDERED TO BE RELEVANT</td></tr>
<tr><td>Category*</td><td>Citation of document, with indication, where appropriate, of the relevant passages</td><td>Relevant to claim No.</td></tr>
<tr><td>A</td><td>JP 2010-191144 A (TOPPAN PRINTING CO., LTD.) 02 September 2010 (2010-09-02), claims, examples, entire text</td><td>1-12</td></tr>
<tr><td>A</td><td>JP 2000-308846 A (TOPPAN PRINTING CO., LTD.) 07 November 2000 (2000-11-07), claims, examples, entire text</td><td>1-12</td></tr>
<tr><td>A</td><td>WO 2020/027037 A1 (NIDEC CORPORATION) 06 February 2020 (2020-02-06), claims, examples, entire text</td><td>1-12</td></tr>
<tr><td>A</td><td>JP 2020-519557 A (CORNING INC.) 02 July 2020 (2020-07-02), claims, examples, entire text</td><td>1-12</td></tr>
<tr><td>A</td><td>WO 2014/129333 A1 (ASAHI GLASS CO., LTD.) 28 August 2014 (2014-08-28), claims, examples, entire text</td><td>1-12</td></tr>
<tr><td>A</td><td>JP 2011-013654 A (SEIKO EPSON CORPORATION) 20 January 2011 (2011-01-20), claims, examples, entire text</td><td>1-12</td></tr>
<tr><td>A</td><td>WO 2018/193742 A1 (SHIN-ETSU CHEMICAL CO., LTD.) 25 October 2018 (2018-10-25), claims, examples, entire text</td><td>1-12</td></tr>
</table>

Form PCT/ISA/210 (second sheet) (January 2015)

## INTERNATIONAL SEARCH REPORT

| International application No. |
| --- |
| PCT/JP2021/026794 |

**Box No. II        Observations where certain claims were found unsearchable (Continuation of item 2 of first sheet)**

This international search report has not been established in respect of certain claims under Article 17 (2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III        Observations where unity of invention is lacking (Continuation of item 3 of first sheet)**

This International Searching Authority found multiple inventions in this international application, as follows:

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**        ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet) (January 2015)

**INTERNATIONAL SEARCH REPORT**

| International application No. |
|---|
| PCT/JP2021/026794 |

| Box No. III      Observations where unity of invention is lacking (Continuation of item 3 of first sheet) |
|---|

This International Searching Authority found multiple inventions in this international application, as follows:

(Invention 1) Claims 1 and 3-12

Claims 1 and 3-12 have the special technical feature of "a surface treatment step for treating the surface of the optical functional layer such that the rate of change in surface roughness represented by formula (1) below is 1-25%, or the rate of change in average length of elements represented by formula (2) below is 7-65%"; thus these claims are classified as invention 1.

(Invention 2) Claim 2

Claim 2 has the common technical feature between this claim and claim 1 classified as invention 1 of "a method for manufacturing an optical laminate formed by laminating a plastic film, an adhesion layer, an optical functional layer, and an anti-fouling layer in order, the method including: an adhesion layer forming step for forming an adhesion layer; an optical functional layer forming step for forming an optical functional layer"; "a surface treatment step for treating the surface of the optical functional layer, and an anti-fouling layer forming step for forming an anti-fouling layer on the optical functional layer subjected to the surface treatment". However, this technical feature, which does not make a contribution over the prior art in light of the disclosure of document 1, cannot be considered a special technical feature. Apart from this feature, there are not the same or corresponding special technical features between these inventions.

Furthermore, claim 2 does not depend from claim 1. In addition, claim 2 is not substantially identical to or similarly closely related to any of the claims classified as invention 1.

Accordingly claim 2 cannot be identified as invention 1.

Meanwhile, claim 2 has the special technical feature of including "a surface treatment step for subjecting the surface of the optical functional layer to glow-discharge treatment", wherein "a summation of the output of the glow-discharge treatment is 130W·min/m2 to 2000W·min/m2 inclusive"; thus this claim is classified as invention 2.

Form PCT/ISA/210 (continuation of first sheet) (January 2015)

EP 4 183 573 A1

International application No.

PCT/JP2021/026794

| | | |
|---|---|---|
| WO 2019/078313 A1 | 25 April 2019 | US 2020/0239360 A1<br>claims, paragraphs [0007], [0016],<br>[0033], [0043], [0050]-[0052],<br>[0072]-[0101], examples<br>DE 102019003930 A<br>CN 111246997 A<br>CN 109683223 A |
| WO 2019/064969 A1 | 04 April 2019 | JP 2019-66515 A<br>KR 10-2020-0037413 A<br>CN 111183373 A<br>TW 201919866 A |
| JP 2008-062460 A | 21 March 2008 | (Family: none) |
| CN 105835465 A | 10 August 2016 | (Family: none) |
| JP 2010-191144 A | 02 September 2010 | (Family: none) |
| JP 2000-308846 A | 07 November 2000 | (Family: none) |
| WO 2020/027037 A1 | 06 February 2020 | (Family: none) |
| JP 2020-519557 A | 02 July 2020 | US 2018/0319704 A1<br>claims, examples<br>WO 2018/208760 A1<br>EP 3621929 A1<br>TW 201900578 A<br>KR 10-2020-0004369 A<br>CN 110997587 A |
| WO 2014/129333 A1 | 28 August 2014 | US 2015/0338552 A1<br>claims, examples<br>CN 105008967 A<br>KR 10-2015-0118156 A<br>TW 201440902 A |
| JP 2011-013654 A | 20 January 2011 | US 2010/0103523 A1<br>claims, examples<br>EP 2180355 A1 |
| WO 2018/193742 A1 | 25 October 2018 | CN 110537116 A<br>KR 10-2019-0137117 A<br>TW 201843290 A |

Form PCT/ISA/210 (patent family annex) (January 2015)

**EP 4 183 573 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020123317 A
- JP 2021032929 A
- WO 2019078313 A
- JP 2006175438 A
- JP 2005301208 A
- JP 6542970 B